# EUROPEAN PATENT APPLICATION

(11) **EP 4 539 098 A1**
(43) Date of publication of application: **16.04.2025**
(21) Application number: 23819904.6
(22) Date of filing: 09.06.2023
(51) Int. Cl.: H01L 21/02, H01L 21/3205, H01L 21/768, H01L 23/522, H01L 25/065, H01L 25/07, H01L 25/18, H01L 27/146

(54) **SEMICONDUCTOR DEVICE AND IMAGING DEVICE**

(30) Priority: 10.06.2022 JP 2022094132
(71) Applicant: Sony Semiconductor Solutions Corporation, Atsugi-shi, Kanagawa 243-0014 (JP)
(72) Inventor: YAMADA, Kyosuke, Atsugi-shi, Kanagawa 243-0014 (JP); FUJIMAGARI, Junichiro, Atsugi-shi, Kanagawa 243-0014 (JP); ONODERA, Takumi, Atsugi-shi, Kanagawa 243-0014 (JP); MOMIUCHI, Yuriko, Atsugi-shi, Kanagawa 243-0014 (JP)
(74) Representative: MFG Patentanwälte Meyer-Wildhagen Meggle-Freund Gerhard PartG mbB
(86) International application number: PCT/JP2023/021495
(87) International publication number: WO 2023/238924

(57) **Abstract**

The present disclosure relates to a semiconductor device and an imaging device that allow a reduction in manufacturing cost.

The semiconductor device includes a first semiconductor in which a plurality of first bonding electrodes is formed, a second semiconductor in which second bonding electrodes each bonded to a corresponding one of the first bonding electrodes are formed, the second semiconductor being smaller in planar size than the first semiconductor, and a third semiconductor in which third bonding electrodes each bonded to a corresponding one of the first bonding electrodes are formed, the third semiconductor being smaller in planar size than the first semiconductor. The second semiconductor and the third semiconductor are bonded to the same surface of the first semiconductor. The third bonding electrodes include electrodes formed to be larger in planar size than the second bonding electrodes. The present disclosure can be applied to, for example, a solid-state imaging device and the like.

## Description

### TECHNICAL FIELD

The present disclosure relates to a semiconductor device and an imaging device, and more particularly, to a semiconductor device and an imaging device that allow a reduction in manufacturing cost.

### BACKGROUND ART

For the purpose of enhancing the functionality of an imaging device, proposed is a solid-state imaging device in which two semiconductor substrates including a second semiconductor substrate in which a memory circuit is mounted and a third semiconductor substrate in which a logic circuit is mounted are bonded by CuCu bonding to a circuit surface on the opposite side from a light incident surface of a first semiconductor substrate in which a photoelectric conversion element is formed (see, for example, Patent Document 1).

In the structure disclosed in Patent Document 1, pad sizes of bonding pads for bonding the first semiconductor substrate and the second and third semiconductor substrates and pitches between adjacent pads are made uniform to adapt to one semiconductor substrate requiring fine connections.

### CITATION LIST

### PATENT DOCUMENT

Patent Document 1: WO 2019/087764 A

### SUMMARY OF THE INVENTION

### PROBLEMS TO BE SOLVED BY THE INVENTION

However, the structure in which the pad sizes and pitches of the bonding pads are made uniform between two semiconductor substrates requires the use of a process that is more advanced than necessary for the other semiconductor substrate that does not require fine connections. As a result, there are concerns about an increase in cost and deterioration in yield due to the use of the advanced process, such as an increase in cost of a photomask for fine patterning or an increase in investment cost for processing equipment.

The present disclosure has been made in view of such circumstances, and it is therefore an object of the present disclosure to enable a semiconductor device having a structure in which a plurality of semiconductors is bonded to a first semiconductor to reduce a manufacturing cost.

### SOLUTIONS TO PROBLEMS

A semiconductor device according to a first aspect of the present disclosure including:
a first semiconductor in which a plurality of first bonding electrodes is formed;
a second semiconductor in which second bonding electrodes each bonded to a corresponding one of the first bonding electrodes are formed, the second semiconductor being smaller in planar size than the first semiconductor; and
a third semiconductor in which third bonding electrodes each bonded to a corresponding one of the first bonding electrodes are formed, the third semiconductor being smaller in planar size than the first semiconductor, in which
the second semiconductor and the third semiconductor are bonded to the same surface of the first semiconductor, and
the third bonding electrodes include electrodes formed to be larger in planar size than the second bonding electrodes.

An imaging device according to a second aspect of the present disclosure including:
a first semiconductor in which a plurality of first bonding electrodes is formed;
a second semiconductor in which second bonding electrodes each bonded to a corresponding one of the first bonding electrodes are formed, the second semiconductor being smaller in planar size than the first semiconductor; and
a third semiconductor in which third bonding electrodes each bonded to a corresponding one of the first bonding electrodes are formed, the third semiconductor being smaller in planar size than the first semiconductor, in which
the second semiconductor and the third semiconductor are bonded to a same surface of the first semiconductor, and
the third bonding electrodes include electrodes formed to be larger in planar size than the second bonding electrodes.

In the first and second aspects of the present disclosure, provided are the first semiconductor in which the plurality of first bonding electrodes is formed, the second semiconductor in which the second bonding electrodes each bonded to a corresponding one of the first bonding electrodes are formed, the second semiconductor being smaller in planar size than the first semiconductor, and the third semiconductor in which the third bonding electrodes each bonded to a corresponding one of the first bonding electrodes are formed, the third semiconductor being smaller in planar size than the first semiconductor, the second semiconductor and the third semiconductor are bonded to the same surface of the first semiconductor, and the third bonding electrodes include electrodes formed to be larger in planar size than the second bonding electrodes.

The semiconductor device and the imaging device may be stand-alone devices, or modules incorporated in other devices.

### BRIEF DESCRIPTION OF DRAWINGS

Fig. 1 is a cross-sectional view of a first embodiment of an imaging device to which the present technology is applied.
Fig. 2 is a plan view of an arrangement example of bonding electrodes of the imaging device according to the first embodiment.
Fig. 3 is a block diagram depicting a schematic configuration of the imaging device in Fig. 1.
Fig. 4 is a diagram for describing a method for manufacturing the imaging device in Fig. 1.
Fig. 5 is a diagram for describing the method for manufacturing the imaging device in Fig. 1.
Fig. 6 is a diagram for describing the method for manufacturing the imaging device in Fig. 1.
Fig. 7 is a cross-sectional view of a second embodiment of the imaging device to which the present technology is applied.
Fig. 8 is a plan view of an arrangement example of bonding electrodes of the imaging device according to the second embodiment.
Fig. 9 is a cross-sectional view of a third embodiment of the imaging device to which the present technology is applied.
Fig. 10 is a plan view of an arrangement example of bonding electrodes of the imaging device according to the third embodiment.
Fig. 11 is a plan view of another arrangement example of the bonding electrodes of the imaging device according to the third embodiment.
Fig. 12 is a cross-sectional view of a fourth embodiment of the imaging device to which the present technology is applied.
Fig. 13 is a cross-sectional view of a first modification of the bonding electrodes.
Fig. 14 is a cross-sectional view of a second modification of the bonding electrodes.
Fig. 15 is a cross-sectional view of a third modification of the bonding electrodes.
Fig. 16 is a diagram for describing a method for manufacturing the bonding electrodes of the third modification.
Fig. 17 is a cross-sectional view of a fourth modification of the bonding electrodes.
Fig. 18 is a cross-sectional view of a fifth modification of the bonding electrodes.
Fig. 19 is a cross-sectional view of a sixth modification of the bonding electrodes.
Fig. 20 is a plan view of a seventh modification of the bonding electrodes.
Fig. 21 is a plan view of the seventh modification of the bonding electrodes.
Fig. 22 is a diagram for describing a usage example of an image sensor.
Fig. 23 is a block diagram depicting a configuration example of an electronic device to which the present technology is applied.
Fig. 24 is a block diagram depicting an example of a schematic configuration of a vehicle control system.
Fig. 25 is a diagram of assistance in explaining an example of installation positions of an outside-vehicle information detecting section and an imaging section.

### MODE FOR CARRYING OUT THE INVENTION

Hereinafter, modes for carrying out the present technology (hereinafter, referred to as embodiments) will be described with reference to the accompanying drawings. The description will be given in the following order.
1. First embodiment of imaging device
2. Method for manufacturing imaging device
3. Second embodiment of imaging device
4. Third embodiment of imaging device
5. Fourth embodiment of imaging device
6. Modifications of bonding electrode
7. Usage example of imaging device
8. Application example to electronic device
9. Application example to mobile object

Note that, in the drawings referred to in the following description, the same or similar parts are denoted by the same or similar reference signs, and redundant description will be omitted as appropriate. The drawings are schematic, and the relationship between the thickness and the plane dimension, the ratio of the thickness of each layer, and the like are different from the actual ones. Furthermore, the drawings may include portions having different dimensional relationships and ratios.

Furthermore, the definitions of directions such as upward and downward in the following description are merely definitions for convenience of description, and do not limit the technical idea of the present disclosure. For example, when an object is observed with the object rotated by 90°, the up and down are converted into and read as left and right, and when the object is observed with the object rotated by 180°, the up and down are inverted and read.

Hereinafter, embodiments of an imaging device (CMOS solid-state imaging device) to which the present technology is applied will be described, but the present technology can be applied to any semiconductor device.

### <1. First embodiment of imaging device>

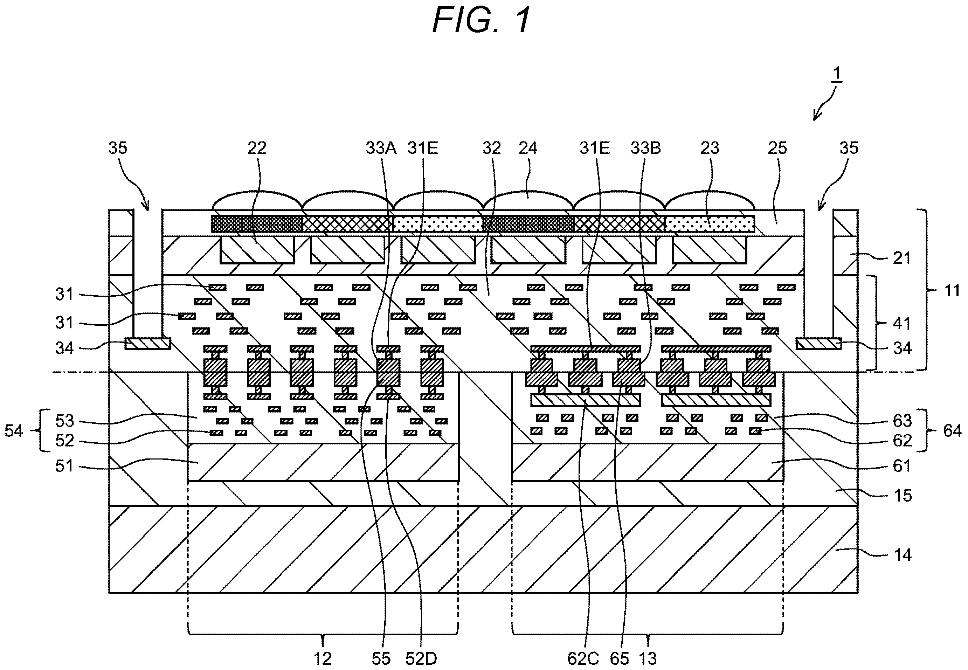

Fig. 1 is a cross-sectional view of a first embodiment of the imaging device to which the present technology is applied.

An imaging device 1 depicted in Fig. 1 is a CMOS solid-state imaging device in which pixels each including a photoelectric conversion element are arranged in a matrix.

The imaging device 1 has a multilayer structure in which a second semiconductor 12 and a third semiconductor 13 that are semiconductor chips smaller in planar size than a first semiconductor 11 as a main substrate are directly bonded sub-substrates to the first semiconductor 11. A long dashed short dashed line depicted in Fig. 1 indicates a bonding interface between the first semiconductor 11, and the second semiconductor 12 and the third semiconductor 13. The multilayer structure of the first semiconductor 11, and the second semiconductor 12 and the third semiconductor 13 is connected to a support substrate 14.

The first semiconductor 11 is a sensor substrate in which each pixel including a photoelectric conversion element is formed. The second semiconductor 12 is a logic substrate in which a logic circuit is formed. The logic circuit includes a signal processing circuit that processes a signal generated in each pixel, an AI processing circuit that performs AI processing (recognition processing) based on the signal generated in each pixel, and the like. The third semiconductor 13 is a memory substrate in which a memory circuit for storing signals processed by the logic circuit of the second semiconductor 12 is formed.

The first semiconductor 11 includes a semiconductor substrate 21 using, for example, silicon (Si). In the semiconductor substrate 21, a photodiode 22 as the photoelectric conversion element is formed for each pixel. A color filter 23 and an on-chip lens 24 are formed for each pixel on a light incident surface side, which is the upper side in the drawing, of the semiconductor substrate 21. A planarizing film 25 is formed above and below the color filter 23, and the on-chip lens 24 is formed on the planarizing film 25.

A wiring layer 41 including a plurality of layers of metal wirings 31 and an insulating layer 32 is formed on a circuit formation surface side of the semiconductor substrate 21, which is the lower side in the drawing, opposite to the light incident surface side. In the example in Fig. 1, five layers of metal wirings 31 are formed, but the number of layers of metal wirings 31 is not particularly limited. Furthermore, a plurality of bonding electrodes 33 is formed on the bonding interface with the second semiconductor 12 and the third semiconductor 13, which is the lower surface of the wiring layer 41. The plurality of bonding electrodes 33 includes a bonding electrode 33A and a bonding electrode 33B, the bonding electrode 33A is electrically connected to a bonding electrode 55 of the second semiconductor 12 by CuCu bonding, and the bonding electrode 33B is electrically connected to a bonding electrode 65 of the third semiconductor 13 by CuCu bonding. Regarding the bonding electrode 33A, each bonding electrode 33A is connected on a one-to-one basis to a corresponding metal wiring 31E, which is the lowermost metal wiring 31; on the other hand, regarding the bonding electrode 33B, a plurality of the bonding electrodes 33B (three bonding electrodes 33B in Fig. 1) is connected together via one metal wiring 31E and is thus short-circuited. Examples of a material of the metal wiring 31 and the bonding electrode 33 may include copper (Cu), tungsten (W), aluminum (Al), gold (Au), and the like. In the present embodiment, the metal wiring 31 and the bonding electrode 33 include copper. The insulating layer 32 includes, for example, an SiO2 film, a low dielectric constant insulating film (Low-k film), an SiOC film, or the like. The insulating layer 32 may include a plurality of insulating films including different materials.

The first semiconductor 11 includes a plurality of pads 34 electrically connected to an external device by wire bonding or the like. Each pad 34 is arranged on an outer peripheral portion outside a pixel array unit in plan view. The pixel array unit is a region in which a plurality of pixels each having the photodiode 22 and the like formed therein is arranged in a matrix, and is formed in a central portion of the first semiconductor 11 in plan view. A through hole 35 passing through the semiconductor substrate 21 is formed above the pad 34, and a part of the upper surface of the pad 34 on which a wire bond ball is formed is exposed via the through hole 35.

On the other hand, the second semiconductor 12 includes a semiconductor substrate 51 using, for example, silicon (Si) and a wiring layer 54 including a plurality of layers of metal wirings 52 and an insulating layer 53 on a front surface of the semiconductor substrate 51 adjacent to the first semiconductor 11. In the example in Fig. 1, four layers of metal wirings 52 are formed, but the number of layers of metal wirings 52 is not particularly limited. Furthermore, a plurality of the bonding electrodes 55 is formed on the bonding interface with the first semiconductor 11, which is the upper surface of the wiring layer 54. Each bonding electrode 55 is electrically connected to the corresponding bonding electrode 33A of the first semiconductor 11 by CuCu bonding. Each bonding electrode 55 is connected on a one-to-one basis to a corresponding metal wiring 52D, which is the uppermost metal wiring 52. Examples of a material of the metal wiring 52 and the bonding electrode 55 may include copper (Cu), tungsten (W), aluminum (Al), gold (Au), and the like. In the present embodiment, the metal wiring 52 and the bonding electrode 55 include copper. The insulating layer 53 includes, for example, an SiO2 film, a low dielectric constant insulating film (Low-k film), an SiOC film, or the like. The insulating layer 53 may include a plurality of insulating films including different materials.

The third semiconductor 13 includes a semiconductor substrate 61 using, for example, silicon (Si) and a wiring layer 64 including a plurality of layers of metal wirings 62 and an insulating layer 63 on a front surface of the semiconductor substrate 61 adjacent to the first semiconductor 11. In the example in Fig. 1, three layers of metal wirings 62 are formed, but the number of layers of metal wirings 62 is not particularly limited. Furthermore, a plurality of the bonding electrodes 65 is formed on the bonding interface with the first semiconductor 11, which is the upper surface of the wiring layer 64. Each bonding electrode 65 is electrically connected to the corresponding bonding electrode 33B of the first semiconductor 11 by CuCu bonding. Regarding the bonding electrode 65, a plurality of the bonding electrodes 65 (three bonding electrodes 65 in Fig. 1) is connected together via one metal wiring 62C and is thus short-circuited. Examples of a material of the metal wiring 62 and the bonding electrode 65 may include copper (Cu), tungsten (W), aluminum (Al), gold (Au), and the like. In the present embodiment, two layers of metal wirings 62 adjacent to the semiconductor substrate 61 and the bonding electrode 65 include copper, but the metal wiring 62C connected to the bonding electrode 65 includes aluminum. The insulating layer 63 includes, for example, an SiO2 film, a low dielectric constant insulating film (Low-k film), an SiOC film, or the like. The insulating layer 63 may include a plurality of insulating films including different materials.

An insulating layer 15 is formed between the first semiconductor 11 and the support substrate 14 except for a region where the second semiconductor 12 and the third semiconductor 13 are connected, and the second semiconductor 12 and the third semiconductor 13 are embedded in the insulating layer 15. The material of the insulating layer 15 is similar to the material of the other insulating layers such as the insulating layer 32, the insulating layer 53, and the insulating layer 63.

The support substrate 14 includes a semiconductor substrate using, for example, silicon (Si), and is bonded to the second semiconductor 12 and the third semiconductor 13 with the insulating layer 15 interposed between the support substrate 14, and the second semiconductor 12 and the third semiconductor 13. In a region where the support substrate 14 is not bonded to the second semiconductor 12 and the third semiconductor 13, the support substrate 14 is bonded to the first semiconductor 11 with the insulating layer 15 interposed between the support substrate 14 and the first semiconductor 11.

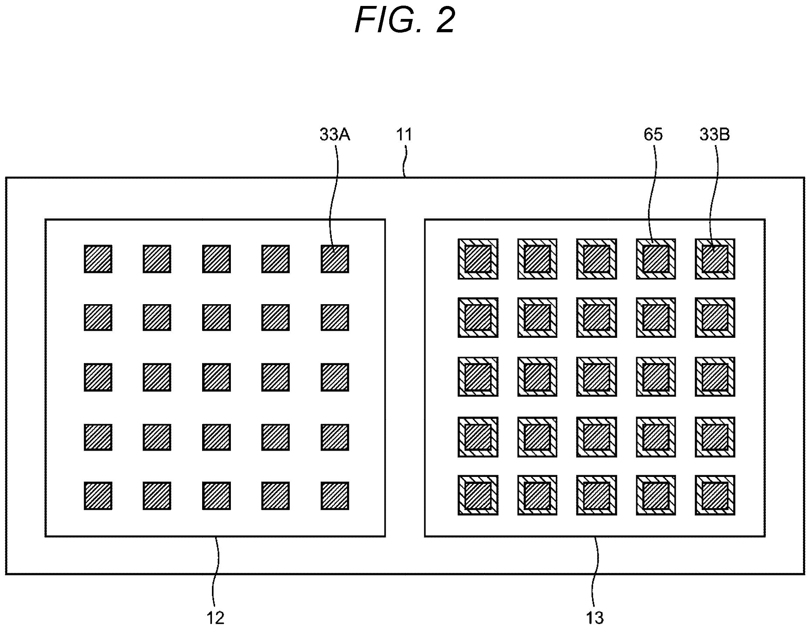

Fig. 2 is a plan view of an arrangement example of the bonding electrodes for bonding the first semiconductor 11, and the second semiconductor 12 and the third semiconductor 13.

The first semiconductor 11 is larger in planar size than the second semiconductor 12 and the third semiconductor 13, and the second semiconductor 12 and the third semiconductor 13 are each formed with a planar size that falls within a planar region of the first semiconductor 11. In the present embodiment, for the sake of simplicity, an example where the second semiconductor 12 and the third semiconductor 13 have the same planar size has been given, but the second semiconductor 12 and the third semiconductor 13 may have different planar sizes.

As depicted in Fig. 2, a plurality of the bonding electrodes 33A of the first semiconductor 11 and a plurality of the bonding electrodes 55 (not depicted) of the second semiconductor 12 are formed in a predetermined array in an overlapping region between the first semiconductor 11 and the second semiconductor 12. Furthermore, a plurality of the bonding electrodes 33B of the first semiconductor 11 and a plurality of bonding electrodes 65 of the third semiconductor 13 are formed in a predetermined array in an overlapping region between the first semiconductor 11 and the third semiconductor 13.

Fig. 2 is a plan view of the bonding interface as viewed from the first semiconductor 11 side, and the bonding electrode 55 of the second semiconductor 12 is arranged at the same position and with the same size as the bonding electrode 33A of the first semiconductor 11, so that the bonding electrode 55 (not depicted) of the second semiconductor 12 coincides with the bonding electrode 33A of the first semiconductor 11 and is thus not visible.

On the other hand, the bonding electrode 65 of the third semiconductor 13 is formed to be larger in planar size than the bonding electrode 33B of the first semiconductor 11, so that the bonding electrode 65 is formed to partially stick out over the bonding electrode 33B. Note that, in the cross-sectional view of Fig. 1, the bonding electrode 65 of the third semiconductor 13 and the bonding electrode 33B of the first semiconductor 11 are depicted in the same pattern (hatching), but in the plan view of Fig. 2, the bonding electrode 65 and the bonding electrode 33B are depicted in different patterns in order to clearly show the difference in size.

The arrangement of the bonding electrodes 33, 55, and 65 in Fig. 2 is depicted in a simplified manner for simplicity of description, and the arrangement and number of the bonding electrodes 33, 55, and 65 are not limited to this example.

As described above, the imaging device 1 includes the first semiconductor 11 as a main substrate, and the second semiconductor 12 and the third semiconductor 13, which are semiconductor chips smaller in planar size than the first semiconductor 11, the first semiconductor 11, and the second semiconductor 12 and the third semiconductor 13 being directly bonded together. The second semiconductor 12 and the third semiconductor 13 are bonded to the same surface of the first semiconductor 11, more specifically, a surface on the opposite side of the first semiconductor 11 from the light incident surface.

A plurality of the bonding electrodes 33 (bonding electrodes 33A or 33B) is formed in the wiring layer 41 of the first semiconductor 11, each bonding electrode 33A of the first semiconductor 11 and the corresponding bonding electrode 55 of the second semiconductor 12 are electrically connected by CuCu bonding, and each bonding electrode 33B of the first semiconductor 11 and the corresponding bonding electrodes 65 of the third semiconductor 13 are electrically connected by CuCu bonding. The bonding electrode 33A bonded to the bonding electrode 55 of the second semiconductor 12 and the bonding electrode 33B bonded to the bonding electrode 65 of the third semiconductor 13 are formed with the same planar size. The bonding electrode 55 of the second semiconductor 12 is formed with the same planar size as of the bonding electrode 33A of the first semiconductor 11, and the bonding electrode 65 of the third semiconductor 13 is formed to be larger in planar size than the bonding electrode 33B of the first semiconductor 11. A comparison between the planar size of the bonding electrode 55 of the second semiconductor 12 and the planar size of the bonding electrode 65 of the third semiconductor 13 shows that the bonding electrode 65 of the third semiconductor 13 is formed to be larger than the bonding electrode 55 of the second semiconductor 12.

There is a possibility that the second semiconductor 12 and the third semiconductor 13, which are two semiconductor chips bonded to the first semiconductor 11, have electrode pads required for external connections with different planar sizes. For example, in a case where a general-purpose semiconductor chip is used as the third semiconductor 13 having a memory circuit, the planar size or pitch of the electrode pad of the third semiconductor 13 may be larger than the planar size or pitch of the electrode pad of the second semiconductor 12, which is the other semiconductor chip. The metal wiring 62C of the third semiconductor 13 in Fig. 1 is an original electrode pad of the general-purpose semiconductor chip, and the planar size and pitch of the metal wiring 62C are larger than the planar size and pitch of the bonding electrode 55 of the second semiconductor 12. Therefore, the imaging device 1 has a configuration where the bonding electrode 65 larger in planar size the bonding electrode 55 of the second semiconductor 12 is formed above the metal wiring 62C, and a plurality of the bonding electrodes 65 is connected to one metal wiring 62C. Then, the bonding electrode 65 and the bonding electrode 33B of the first semiconductor 11 are electrically connected by CuCu bonding.

Making the bonding electrode 65 of the third semiconductor 13 larger in planar size than the bonding electrode 55 of the second semiconductor 12 allows a reduction in precision of a photomask and complexity of a process for forming the bonding electrode 65, so that the manufacturing cost can be reduced. Furthermore, since the bonding electrode 65 of the third semiconductor 13 is formed to be larger in planar size than the bonding electrode 33B of the first semiconductor 11, a margin for a bonding misalignment increases, and the yield can be improved accordingly.

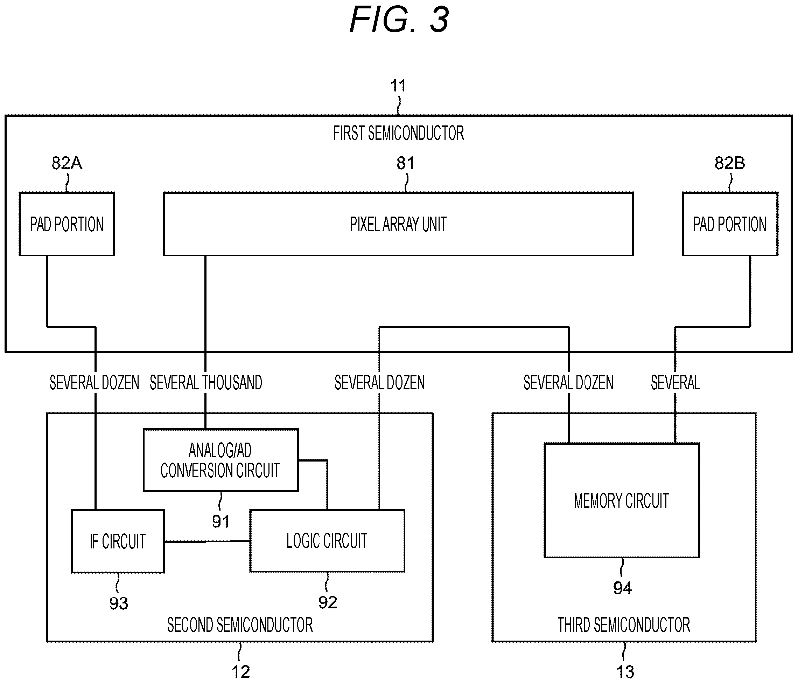

Fig. 3 is a block diagram depicting a schematic configuration of the imaging device 1.

The first semiconductor 11 includes a pixel array unit 81 in which a plurality of pixels each having the photodiode 22 and the like formed therein is arranged in a matrix, and pad portions 82A and 82B. The pad portions 82A and 82B include the plurality of pads 34 depicted in Fig. 1, and each correspond to an input/output portion of the imaging device 1. The pad portion 82A includes a plurality of the pads 34 electrically connected to the second semiconductor 12, and the pad portion 82B includes a plurality of the pads 34 electrically connected to the third semiconductor 13.

The second semiconductor 12 includes an analog/AD conversion circuit 91, a logic circuit 92, and an IF circuit 93. The analog/AD conversion circuit 91 includes an analog signal processing circuit that processes an analog signal output from each pixel of the pixel array unit 81 and an AD conversion circuit that converts the analog signal into a digital signal. The analog/AD conversion circuit 91 outputs the digitized signal (AD-converted signal) to the logic circuit 92. The logic circuit 92 performs various kinds of digital signal processing such as black level adjustment and column variation correction on the signal supplied from the analog/AD conversion circuit 91. The logic circuit 92 outputs the processed signal to the IF circuit 93 or stores the processed signal in a memory circuit 94 of the third semiconductor 13 as necessary. The IF circuit 93 converts the signal supplied from the logic circuit 92 into a predetermined format such as a mobile industry processor interface (MIPI)-compliant format and outputs the converted signal to an external device via the pad portion 82A.

The third semiconductor 13 includes the memory circuit 94 including, for example, a frame memory. The memory circuit 94 stores the data supplied from the logic circuit 92.

Fig. 3 shows the number of electrical connection points (hereinafter, simply referred to as contacts) required between the first semiconductor 11, and the second semiconductor 12 and the third semiconductor 13.

For the transfer of a signal from each pixel between the pixel array unit 81 and the analog/AD conversion circuit 91, up to several thousand contacts are required. Furthermore, for the transfer of data (signal) input to and output from the memory circuit 94 between the logic circuit 92 and the memory circuit 94 via the first semiconductor 11, up to several dozen contacts are required. For the transfer of a power supply voltage, a ground (GND), an input/output signal, and the like between the pad portion 82A and the IF circuit 93, up to several dozen contacts are required. For the transfer of the power supply voltage, the ground (GND), and the like between the pad portion 82B and the memory circuit 94, up to several contacts are required.

As a result of the above, the total number of contacts between the first semiconductor 11 and the second semiconductor 12 is several thousand or more, and it is desirable to reduce capacitance, so that large-scale and fine-pitch bonding electrodes are required. On the other hand, the total number of contacts between the first semiconductor 11 and the third semiconductor 13 may be the same as the number of original electrode pads of the general-purpose semiconductor chip, and may be several dozen to around a hundred, so that the pitch of the contact may be the same as the pitch of the original electrode pad.

This eliminates the need of miniaturization of the bonding electrodes between the first semiconductor 11 and the third semiconductor 13 as compared with the bonding electrodes between the first semiconductor 11 and the second semiconductor 12. When bonding electrodes are formed to adapt to the other bonding electrodes requiring fine connections, the cost increases, and the yield also deteriorates.

In the imaging device 1 according to the first embodiment described above, a plurality of the bonding electrodes 65 for electrically connecting to the corresponding bonding electrodes 33B of the first semiconductor 11 is formed on the metal wiring 62C that is the original electrode pad of the general-purpose semiconductor chip constituting the third semiconductor 13. Making the bonding electrode 65 of the third semiconductor 13 larger in planar size than the bonding electrode 55 of the second semiconductor 12 allows a reduction in precision of the photomask and complexity of the process for forming the bonding electrode 65, so that the manufacturing cost can be reduced. Furthermore, since the bonding electrode 65 of the third semiconductor 13 is formed to be larger in planar size than the bonding electrode 33B of the first semiconductor 11, a margin for a bonding misalignment increases, and the yield can be improved accordingly. Moreover, the use of the general-purpose semiconductor chip as the third semiconductor 13 allows a reduction in overall cost of the imaging device 1.

### <2. Method for manufacturing imaging device>

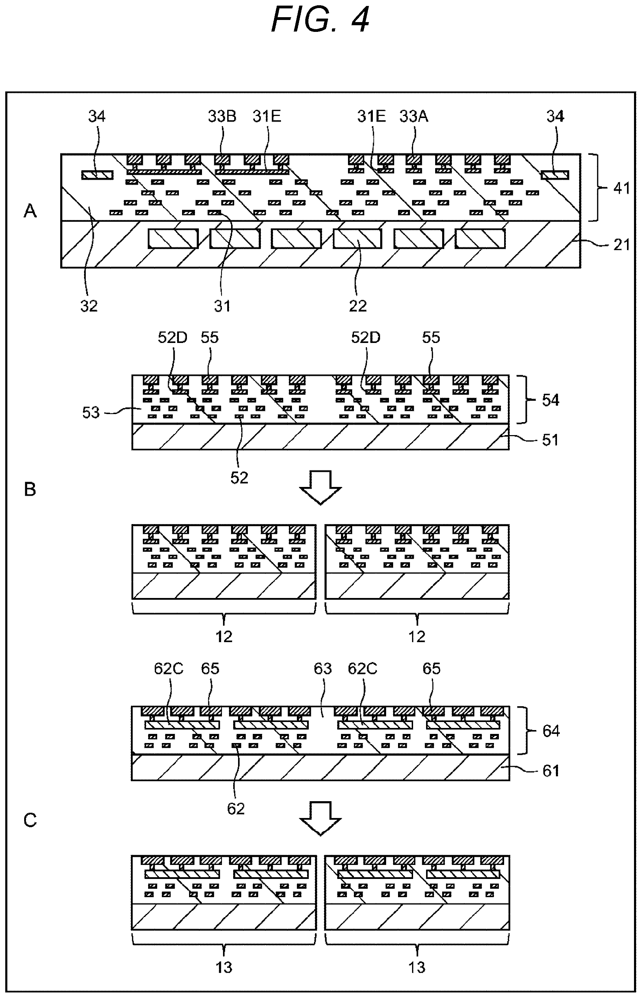

Next, a method for manufacturing the imaging device 1 in Fig. 1 will be described with reference to Figs. 4 to 6.

The imaging device 1 in Fig. 1 is manufactured by a chip on wafer (CoW) technology in which after the second semiconductor 12 and third semiconductor 13 obtained by singulation are bonded and stacked on the first semiconductor 11 in a wafer state, the first semiconductor 11 in a wafer state is diced into chips. In Figs. 4 to 6, only one chip portion is depicted for the first semiconductor 11 due to space limitations, but actually, the first semiconductor 11 is manufactured in a wafer state.

First, as depicted in A of Fig. 4, a plurality of the photodiodes 22 is formed in each chip region to be the first semiconductor 11 of the semiconductor substrate 21 in a wafer state, and the wiring layer 41 is formed on one surface of the semiconductor substrate 21. The one surface of the semiconductor substrate 21 on which the wiring layer 41 is formed corresponds to the front surface of the semiconductor substrate 21. The wiring layer 41 includes a plurality of layers of the metal wirings 31, the insulating layer 32, the bonding electrode 33, the pad 34, and the like. In the present embodiment, copper is used as the material of the metal wiring 31 and the bonding electrode 33, and aluminum is used as the material of the pad 34. The insulating layer 26 includes, for example, an SiO2 film.

Next, as depicted in B of Fig. 4, the wiring layer 54 of the second semiconductor 12 is formed on the semiconductor substrate 51 in a wafer state in a process different from the process in A of Fig. 4. The wiring layer 54 includes a plurality of layers of the metal wirings 52, the insulating layer 53, the bonding electrode 55, and the like. Then, the semiconductor substrate 51 in a wafer state on which the wiring layer 54 is formed is diced into chips, thereby forming semiconductor chips each corresponding to the second semiconductor 12. Copper is used as the material of the metal wiring 52 and the bonding electrode 55, and the insulating layer 53 includes, for example, an SiO2 film.

Next, as depicted in C of Fig. 4, the wiring layer 64 of the third semiconductor 13 is formed on the semiconductor substrate 61 in a wafer state in a process different from the process in A and B of Fig. 4. The wiring layer 64 includes a plurality of layers of the metal wirings 62, the insulating layer 63, the bonding electrode 65, and the like. The bonding electrode 65 is formed to be larger in planar size than the bonding electrode 55 of the second semiconductor 12. Three bonding electrodes 65 are connected to one metal wiring 62C. Then, the semiconductor substrate 61 in a wafer state on which the wiring layer 64 is formed is diced into chips, thereby forming semiconductor chips each corresponding to the third semiconductor 13. The two layers of metal wiring 62 adjacent to the semiconductor substrate 61 and the bonding electrode 65 include copper, but the metal wiring 62C connected to the bonding electrode 65 includes aluminum. The insulating layer 63 includes, for example, an SiO2 film.

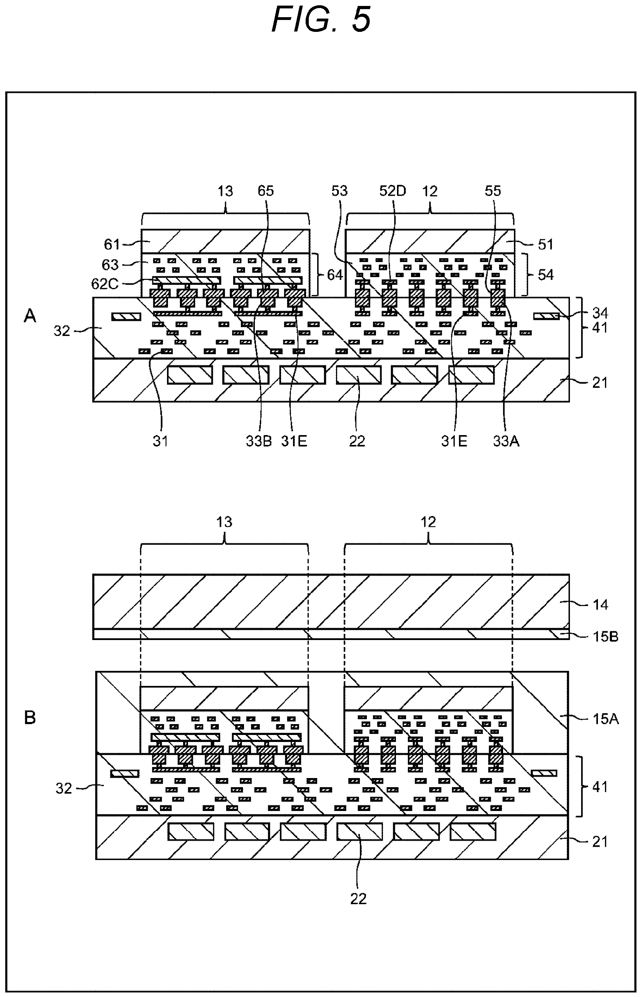

Next, as depicted in A of Fig. 5, the second semiconductor 12 and the third semiconductor 13, which are manufactured in different processes and are subjected to singulation as described above, are each bonded to the corresponding chip region of the semiconductor substrate 21 in a wafer state. More specifically, the bonding electrode 55 of the wiring layer 54 of the second semiconductor 12 and the bonding electrode 33A of the wiring layer 41 of the semiconductor substrate 21 are connected by CuCu bonding, and the insulating layer 53 of the wiring layer 54 of the second semiconductor 12 and the insulating layer 32 of the wiring layer 41 of the semiconductor substrate 21 are connected by oxide film bonding. Furthermore, the bonding electrode 65 of the wiring layer 64 of the third semiconductor 13 and the bonding electrode 33B of the wiring layer 41 of the semiconductor substrate 21 are bonded by CuCu bonding, and the insulating layer 63 of the wiring layer 64 of the third semiconductor 13 and the insulating layer 32 of the wiring layer 41 of the semiconductor substrate 21 are bonded by oxide film bonding. Since the bonding electrode 65 of the third semiconductor 13 is formed to be larger in planar size than the bonding electrode 33B of the first semiconductor 11, a margin for a bonding misalignment increases, and bonding becomes easier accordingly.

Note that, in the present embodiment, since the material of the bonding electrodes 33, 55, and 65 is copper, the metal bonding is CuCu bonding, but the metal bonding may be metal bonding using a different metal material. For example, in a case where the material of the bonding electrodes 33, 55, and 65 is gold (Au), the metal bonding is AuAu bonding.

Next, as depicted in B of Fig. 5, an insulating layer 15A is formed on the upper surface of the wiring layer 41 to be thicker than the second semiconductor 12 and the third semiconductor 13. The insulating layer 15A is embedded in a region (cavity) where neither the second semiconductor 12 nor the third semiconductor 13 is formed, and is then stacked up to a position higher than the height of the second semiconductor 12 and the third semiconductor 13. Subsequently, the insulating layer 15A formed with a thickness sufficient to cover the second semiconductor 12 and the third semiconductor and an insulating layer 15B formed on one surface of the support substrate 14 in a wafer state are bonded together by oxide film bonding. The insulating layer 15 in Fig. 1 includes the insulating layer 15A and the insulating layer 15B. The insulating layer 15A and the insulating layer 15B each include, for example, an oxide film (Si02).

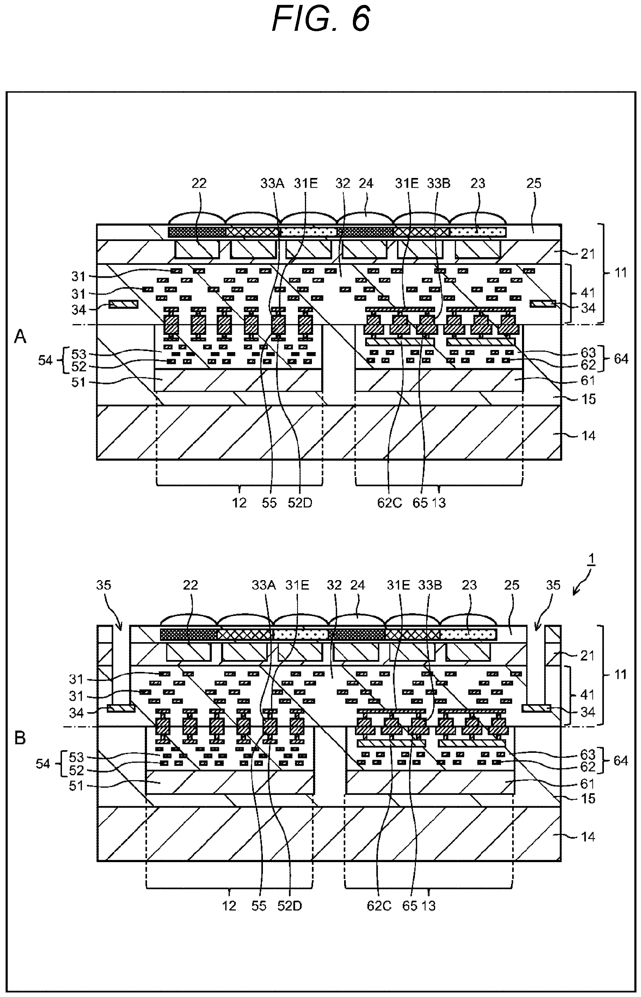

Subsequently, as depicted in A of Fig. 6, after the support substrate 14 in a wafer state is turned upside down so that the support substrate 14 is on the bottom, and the semiconductor substrate 21 in a wafer state is on the top, the semiconductor substrate 21 in a wafer state is thinned so as to bring the photodiode 22 formed in each chip region of the semiconductor substrate 21 into close proximity to the interface. Then, the planarizing film 25, the color filter 23, and the on-chip lens 24 are formed on the thinned semiconductor substrate 21.

Finally, as depicted in B of Fig. 6, the through hole 35 is formed at the position of the pad 34 in the outer peripheral portion of each chip region of the semiconductor substrate 21 to expose the upper surface of the pad 34. As described above, a plurality of the imaging devices 1 in a wafer state is manufactured. The plurality of imaging devices 1 is diced into chips, each of which corresponds to the imaging device 1 in Fig. 1.

### <3. Second embodiment of imaging device>

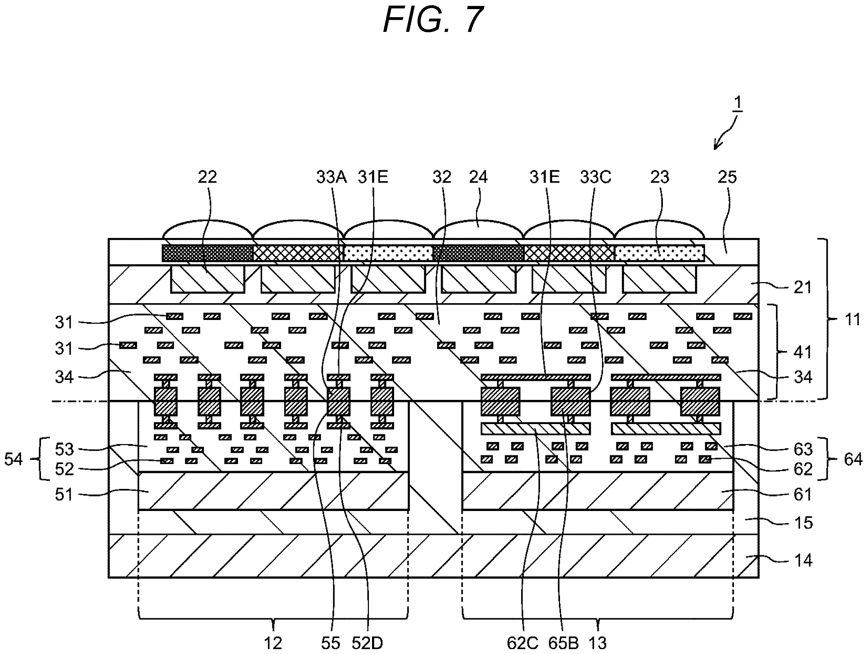

Fig. 7 is a cross-sectional view of a second embodiment of the imaging device to which the present technology is applied.

In Fig. 7, parts corresponding to those of the first embodiment depicted in Fig. 1 are denoted by the same reference signs, description of the parts will be omitted as appropriate, and description focusing on different parts will be given below. Note that the cross-sectional views of the second to fourth embodiments has no depiction of the outer peripheral portion where the plurality of pads 34 is formed.

An imaging device 1 according to the second embodiment in Fig. 7 is different from the first embodiment depicted in Fig. 1 in structure of the bonding electrodes located at the bonded portion between the first semiconductor 11 and the third semiconductor 13. A bonding electrode 33C of the first semiconductor 11 is formed with the same planar size as of the bonding electrode 65 of the third semiconductor 13 that is a mating electrode.

More specifically, in the first embodiment, the bonding electrode 65 of the third semiconductor 13 is formed to be larger in planar size than the bonding electrode 33B of the first semiconductor 11. On the other hand, in the second embodiment, the bonding electrode 33C of the first semiconductor 11 and a bonding electrode 65B of the third semiconductor 13 are formed with the same planar size. In other words, in the first embodiment, the bonding electrode 33A of the first semiconductor 11 bonded to the bonding electrode 55 of the second semiconductor 12, and the bonding electrode 33B of the first semiconductor 11 bonded to the bonding electrode 65 of the third semiconductor 13 are formed with the same planar size and pitch. On the other hand, in the second embodiment, a change is made so as to make the bonding electrode 33C of the first semiconductor 11 bonded to the bonding electrode 65B of the third semiconductor 13 larger in planar size and pitch than the bonding electrode 33A of the first semiconductor 11 bonded to the bonding electrode 55 of the second semiconductor 12. In the third semiconductor 13 of the first embodiment, three bonding electrodes 65 are connected to one metal wiring 62C; on the other hand, in the third semiconductor 13 of the second embodiment, two bonding electrodes 65B are connected to one metal wiring 62C due to the increase in planar size of the bonding electrode 33C of the first semiconductor 11 and the bonding electrode 65B of the third semiconductor 13. Similarly, in the first semiconductor 11, two bonding electrodes 33C are connected to one metal wiring 31E.

The configuration where the bonding electrode 65B of the third semiconductor 13 is formed to be larger in planar size than the bonding electrode 55 of the second semiconductor 12 is common with the first embodiment.

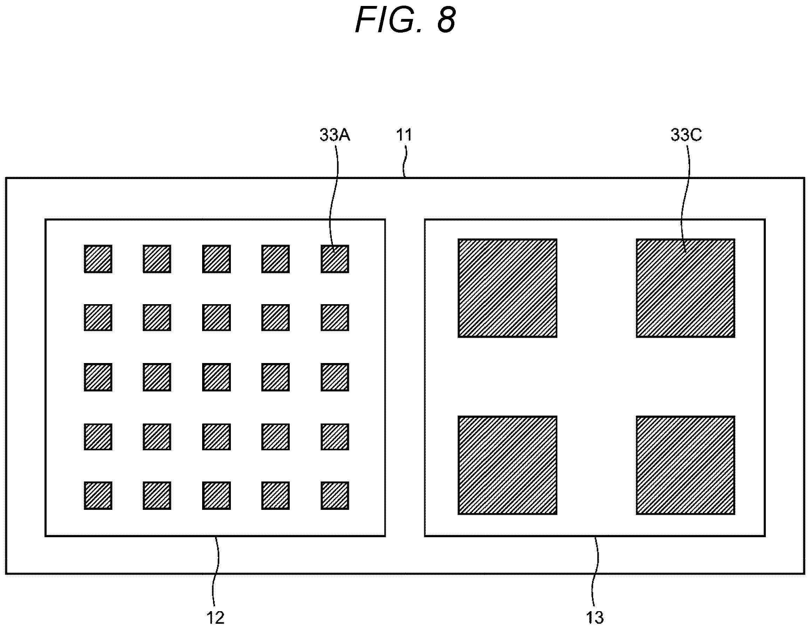

Fig. 8 is a plan view of an arrangement example of the bonding electrodes of the first semiconductor 11 to the third semiconductor 13 in the second embodiment.

The bonding electrode 33A of the first semiconductor 11 and the bonding electrode 55 (not depicted) of the second semiconductor 12 are similar to the bonding electrodes in the first embodiment depicted in Fig. 2. The bonding electrode 55 (not depicted) of the second semiconductor 12 is not visible because the bonding electrode 55 coincides with the bonding electrode 33A of the first semiconductor 11.

On the other hand, the bonding electrode 33C of the first semiconductor 11 is formed to be larger in planar size and pitch than the bonding electrode 33A of the first semiconductor 11. The bonding electrode 33C of the first semiconductor 11 is bonded to the bonding electrode 65B (not depicted) of the third semiconductor 13, but the bonding electrode 65B (not depicted) of the third semiconductor 13 is not visible because the bonding electrode 65B is formed at the same position and with the same size as of the bonding electrode 33C of the first semiconductor 11, and coincides with the bonding electrode 33C.

While the first embodiment described above has an advantage in that common parts having the same planar size and pitch are used for the bonding electrode 33A of the first semiconductor 11 bonded to the bonding electrode 55 of the second semiconductor 12, and the bonding electrode 33B of the first semiconductor 11 bonded to the bonding electrode 65 of the third semiconductor 13, the planar size and pitch of the bonding electrode 33 need to adapt to the second semiconductor 12 side requiring fine connections.

In the second embodiment, according to the bonding electrode 65B of the third semiconductor 13 that is allowed to have a large planar size and a large pitch, the bonding electrode 33C on the first semiconductor 11 side can be formed with a larger planar size and a larger pitch. Making the bonding electrode 33C of the first semiconductor 11 and the bonding electrodes 65B of the third semiconductor 13 larger in planar size and pitch allows a reduction in precision of a photomask and complexity of a process for forming the bonding electrodes 33C and 65B, so that the manufacturing cost can be reduced. Furthermore, a margin for a bonding misalignment increases, and the yield can be improved accordingly. Moreover, the use of the general-purpose semiconductor chip as the third semiconductor 13 allows a reduction in overall cost of the imaging device 1.

### <4. Third embodiment of imaging device>

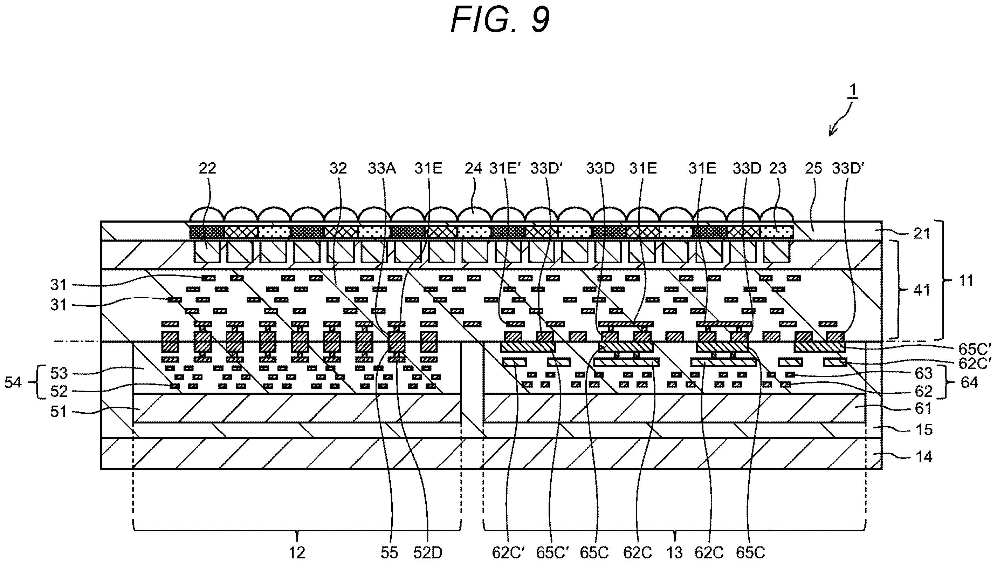

Fig. 9 is a cross-sectional view of a third embodiment of the imaging device to which the present technology is applied.

In Fig. 9, parts corresponding to those of the first embodiment or the second embodiment described above are denoted by the same reference signs, description of the parts will be omitted as appropriate, and description focusing on different parts will be given below.

An imaging device 1 according to the third embodiment in Fig. 9 is also different from the first or second embodiment described above in structure of the bonding electrodes located at the bonded portion between the first semiconductor 11 and the third semiconductor 13.

In the first and second embodiments described above, the bonding electrodes of the first semiconductor 11 and the third semiconductor 13 are bonded on a one-to-one basis. That is, in the first embodiment, one bonding electrode 65 on the third semiconductor 13 side is bonded to one bonding electrode 33B on the first semiconductor 11 side, and in the second embodiment, one bonding electrode 65B on the third semiconductor 13 side is bonded to one bonding electrode 33C on the first semiconductor 11 side.

On the other hand, in the third embodiment, one bonding electrode 65C on the third semiconductor 13 side is bonded to two bonding electrodes 33D on the first semiconductor 11 side. A comparison between the planar size of the bonding electrode 55 of the second semiconductor 12 and the planar size of the bonding electrode 65C of the third semiconductor 13 shows that the bonding electrode 65C is formed to be larger in planar size than the bonding electrode 55, which is common with the first and second embodiments. Accordingly, a configuration where a plurality of the bonding electrodes 33D on the first semiconductor 11 side is bonded to one bonding electrode 65C of the third semiconductor 13 formed with a larger planar size can be employed.

Furthermore, in the imaging device 1 of the third embodiment, among the plurality of bonding electrodes 33D of the first semiconductor 11, a bonding electrode 33D' that is not connected to the upper metal wiring 31E is provided. A bonding electrode 65C' on the third semiconductor 13 side bonded to the bonding electrode 33D' of the first semiconductor 11 is also not connected to the lower metal wiring 62C. The bonding electrode 33D' and the bonding electrode 65C' that are not connected to the upper metal wiring 31E or the lower metal wiring 62C serve as dummy bonding electrodes that do not transfer a power supply voltage, a signal, or the like between the first semiconductor 11 and the third semiconductor 13. Providing such dummy bonding electrodes 33D' and 65C' can reduce the impact of unevenness of the wiring layers 41 and 64.

On the first semiconductor 11 side, a metal wiring 31E' is formed at a position in the same layer as the metal wiring 31E above the dummy bonding electrode 33D' so as to be comparable in wiring density to the metal wiring 31E. On the third semiconductor 13 side, a metal wiring 62C' is formed below the dummy bonding electrode 65C' so as to be comparable in wiring density to the metal wiring 62C. The metal wirings 31E' and 62C' may be wirings through which a predetermined power supply voltage, a signal, or the like is transmitted, or may be dummy wirings through which a predetermined power supply voltage, a signal, or the like is not transmitted.

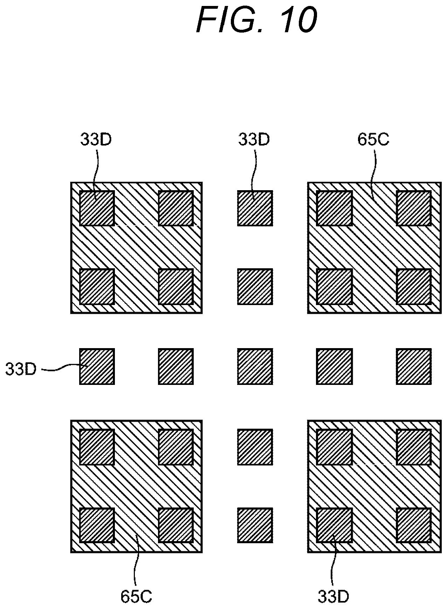

Fig. 10 is a plan view of an arrangement example of the bonding electrodes 33D of the first semiconductor 11 and the bonding electrodes 65C of the third semiconductor 13 in the third embodiment.

In the example in Fig. 10, four bonding electrodes 33D arranged in a 2 × 2 matrix (two in the horizontal direction and two in the vertical direction) are bonded to one bonding electrode 65C. Among the plurality of bonding electrodes 33D of the first semiconductor 11, there is a bonding electrode 33D that is not bonded to any bonding electrode 65C of the third semiconductor 13. Rows and columns of the bonding electrodes 33D that are not bonded to any bonding electrode 65C are arranged between the sets of the four bonding electrodes 33D arranged in a 2 × 2 matrix and bonded to one bonding electrode 65C.

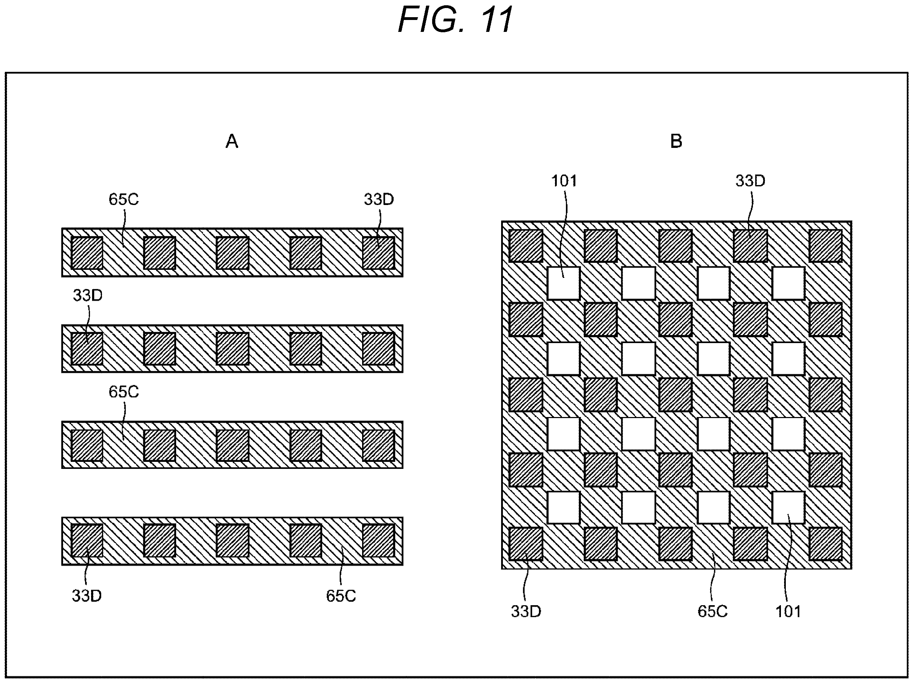

Fig. 11 is a plan view of another arrangement example of the bonding electrodes 33D of the first semiconductor 11 and the bonding electrodes 65C of the third semiconductor 13 in the third embodiment.

In the example in A of Fig. 11, one bonding electrode 65C has an elongated rectangular planar shape, and one bonding electrode 65C is bonded to a plurality of the bonding electrodes 33D arranged in a row in the horizontal direction or the vertical direction.

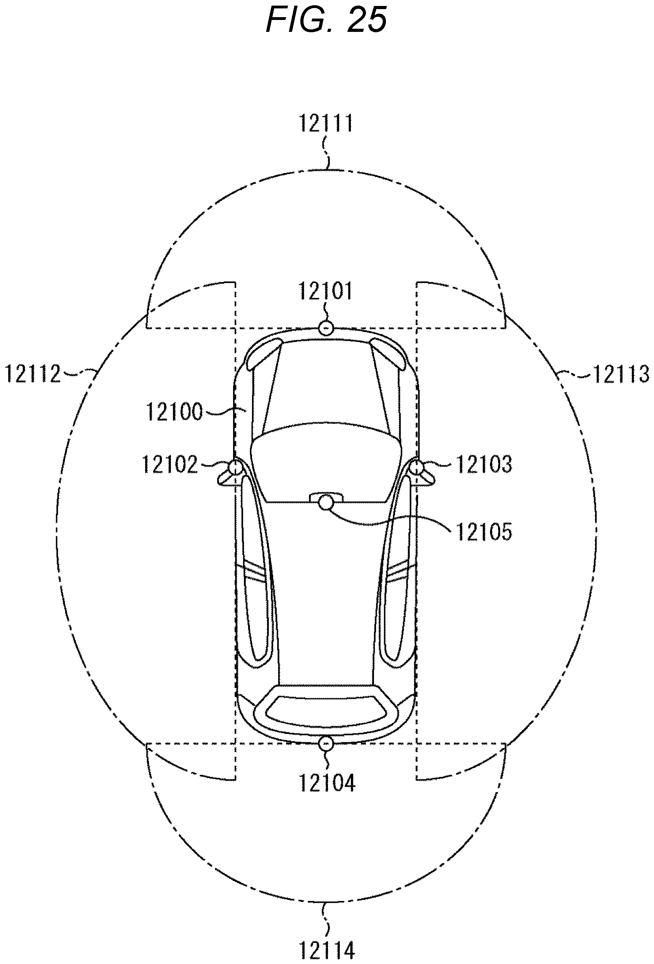

In the example in B of Fig. 11, 25 bonding electrodes 33D arranged in a 5 × 5 matrix (five in the horizontal direction and five in the vertical direction) are bonded to one bonding electrode 65C. The bonding electrode 65C has a plurality of opening regions 101 in a region where no bonding electrode 33D is bonded. A configuration where only the planar size of the bonding electrode 65C is increased to allow a large number of bonding electrodes 33D to be bonded to one bonding electrode 65C makes the bonding electrode 65C prone to dishing. That is, the plane of the bonding electrode 65C becomes prone to concave deformation. As described above, providing the plurality of opening regions 101 in the region where no bonding electrode 33D is bonded can reduce the area of the bonding electrode 65C and suppress the occurrence of dishing. The insulating layer 63 including an SiO2 film or the like is embedded in the opening regions 101.

The planar shape, arrangement, and the number of junctions of the bonding electrode 33D and the bonding electrode 65C described with reference to Figs. 10 and 11 are merely examples, and it goes without saying that other combinations may be adopted.

As described above, in the imaging device 1 according to the third embodiment, the bonding electrode 65C of the third semiconductor 13 is formed to be larger in planar size than the bonding electrode 55 of the second semiconductor 12, and a plurality of the bonding electrodes 33D is bonded to one bonding electrode 65C. Furthermore, the pitch of the bonding electrode 65C is also made larger than the pitch of the bonding electrodes 55 of the second semiconductor 12. Making the bonding electrode 65C of the third semiconductor 13 larger in planar size and pitch allows a reduction in precision of a photomask and complexity of a process for forming the bonding electrode 65C, so that the manufacturing cost can be reduced. Furthermore, a margin for a bonding misalignment increases, and the yield can be improved accordingly. Moreover, the use of the general-purpose semiconductor chip as the third semiconductor 13 allows a reduction in overall cost of the imaging device 1.

### <5. Fourth embodiment of imaging device>

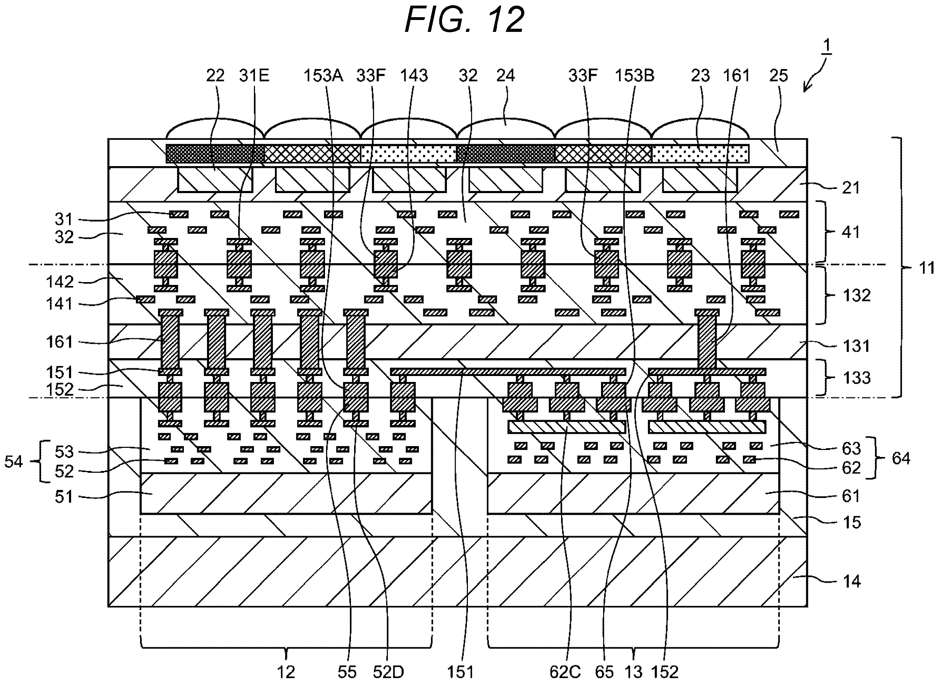

Fig. 12 is a cross-sectional view of a fourth embodiment of the imaging device to which the present technology is applied.

Also in Fig. 12, parts corresponding to those of the first embodiment to the third embodiment described above are denoted by the same reference signs, description of the parts will be omitted as appropriate, and description focusing on different parts will be given below.

An imaging device 1 according to the fourth embodiment depicted in Fig. 12 is different from the above-described first embodiment in that the first semiconductor 11 has a multilayer structure with two semiconductor substrates stacked on top of each other.

Specifically, the first semiconductor 11 includes, in addition to a semiconductor substrate 21 similar to the semiconductor substrate 21 of the first embodiment, a semiconductor substrate 131 using, for example, silicon (Si), and a wiring layer 41 formed on the front surface side of semiconductor substrate 21 and a wiring layer 132 formed on the front surface side of the semiconductor substrate 131 are bonded. A wiring layer 133 is formed on the back surface side of the semiconductor substrate 131, and the wiring layer 133, a wiring layer 54 of the second semiconductor 12, a wiring layer 64 of the third semiconductor 13, and an insulating layer 15 are bonded.

The wiring layer 132 formed on the front surface side of semiconductor substrate 131 includes a plurality of layers of metal wirings 141 and an insulating layer 142. At a bonding interface between the wiring layer 41 and the wiring layer 132, a bonding electrode 33F of the wiring layer 41 and a bonding electrode 143 of the wiring layer 132 are bonded to establish electrical connection. The insulating layer 32 and the insulating layer 142 are bonded by oxide film bonding except for the region where the bonding electrode 33F and the bonding electrode 143 are bonded.

The wiring layer 133 formed on the back surface side of the semiconductor substrate 131 includes one or more layers of metal wirings 151 and an insulating layer 152. At a bonding interface between the wiring layer 133 and the wiring layer 54 of the second semiconductor 12, a bonding electrode 153A of the wiring layer 133 and the bonding electrode 55 of the wiring layer 54 are bonded to establish electrical connection. At a bonding interface between the wiring layer 133 and the wiring layer 64 of the third semiconductor 13, a bonding electrode 153B of the wiring layer 133 and the bonding electrode 65 of the wiring layer 64 are bonded to establish electrical connection. The insulating layer 152 of the wiring layer 133 is bonded to the insulating layer 53 of the second semiconductor 12, the insulating layer 63 of the third semiconductor 13, and the insulating layer 15 by oxide film bonding. The second semiconductor 12 and the third semiconductor 13 are electrically connected via a predetermined metal wiring 151 in the wiring layer 133.

A plurality of through vias 161 passing through the semiconductor substrate 131 is formed in the semiconductor substrate 131, and the first semiconductor 11 and the second semiconductor 12 or the first semiconductor 11 and the third semiconductor 13 are electrically connected via the plurality of through vias 161.

The configuration where the bonding electrode 65 of the third semiconductor 13 is formed to be larger in planar size than the bonding electrode 55 of the second semiconductor 12, a plurality of the bonding electrodes 65 is connected to one metal wiring 62C, and the like is similar to the configuration of the above-described first embodiment.

In the semiconductor substrate 131, the wiring layer 132, and the wiring layer 133 added as compared with the first embodiment, for example, some of the analog/AD conversion circuit 91, the logic circuit 92, and the IF circuit 93 that are all formed in the second semiconductor 12 in the first embodiment can be provided.

Also in the imaging device 1 according to the fourth embodiment configured as described above, making the bonding electrode 65 of the third semiconductor 13 larger in planar size than the bonding electrode 55 of the second semiconductor 12 allows a reduction in precision of a photomask and complexity of a process for forming the bonding electrode 65, so that the manufacturing cost can be reduced. Furthermore, since the bonding electrode 65 of the third semiconductor 13 is formed to be larger in planar size than the bonding electrode 153B of the first semiconductor 11, a margin for a bonding misalignment increases, and the yield can be improved accordingly. Moreover, the use of the general-purpose semiconductor chip as the third semiconductor 13 allows a reduction in overall cost of the imaging device 1.

The imaging device 1 according to the fourth embodiment can also be regarded as a configuration where a fourth semiconductor is added between the first semiconductor 11, and the second semiconductor 12 and the third semiconductor 13 of the first embodiment.

In the imaging device 1 according to the fourth embodiment depicted in Fig. 12, for the bonding structure of the bonding interface between the first semiconductor 11, and the second semiconductor 12 and the third semiconductor 13, the bonding structure of the first embodiment is adopted; however, it goes without saying that the bonding structure of the second embodiment in Fig. 7 or the third embodiment in Fig. 9 may be adopted.

### <6. Modifications of bonding electrode>

Next, modifications of the bonding electrode 33 (33A, 33B), the bonding electrode 55, and the bonding electrode 65 described as the first embodiment will be described.

Briefly describing again the imaging device 1 of the first embodiment including the bonding electrode 33, the bonding electrode 55, and the bonding electrode 65, as described with reference to Figs. 1 and 2, the imaging device 1 includes the first semiconductor 11, the second semiconductor 12, and the third semiconductor 13, and the second semiconductor 12 and the third semiconductor 13 are bonded to the same surface of the first semiconductor 11. The first semiconductor 11 includes the plurality of bonding electrodes 33 (first bonding electrodes), the second semiconductor 12 includes the plurality of bonding electrodes 55 (second bonding electrodes), and the third semiconductor 13 includes the plurality of bonding electrodes 65 (third bonding electrodes). Among the plurality of bonding electrodes 33 of the first semiconductor 11, the bonding electrode 33 bonded to the bonding electrode 55 of the second semiconductor 12 is the bonding electrode 33A, and the bonding electrode 33 bonded to the bonding electrode 65 of the third semiconductor 12 is the bonding electrode 33B. The bonding electrode 65 of the third semiconductor 12 is formed to be larger in planar size than the bonding electrode 33 of the first semiconductor 11 and the bonding electrode 55 of the second semiconductor 12, and the bonding electrode 55 of the second semiconductor 12 is formed with the same planar size as of the bonding electrode 33 (33A) of the first semiconductor 11.

In the imaging device 1 of the first embodiment, a comparison about the planar size and the arrangement pitch between the bonding electrodes 33A and 55 by which the first semiconductor 11 and the second semiconductor 12 are bonded, and the bonding electrodes 33B and 65 by which the first semiconductor 11 and the third semiconductor 13 are bonded shows that the bonding electrode 55 of the second semiconductor 12 is formed to be smaller in planar size than the bonding electrode 55 of the third semiconductor 13. The miniaturization and fine-pitching of the bonding electrodes allow a reduction in volumes of the bonding electrodes 33A and 55.

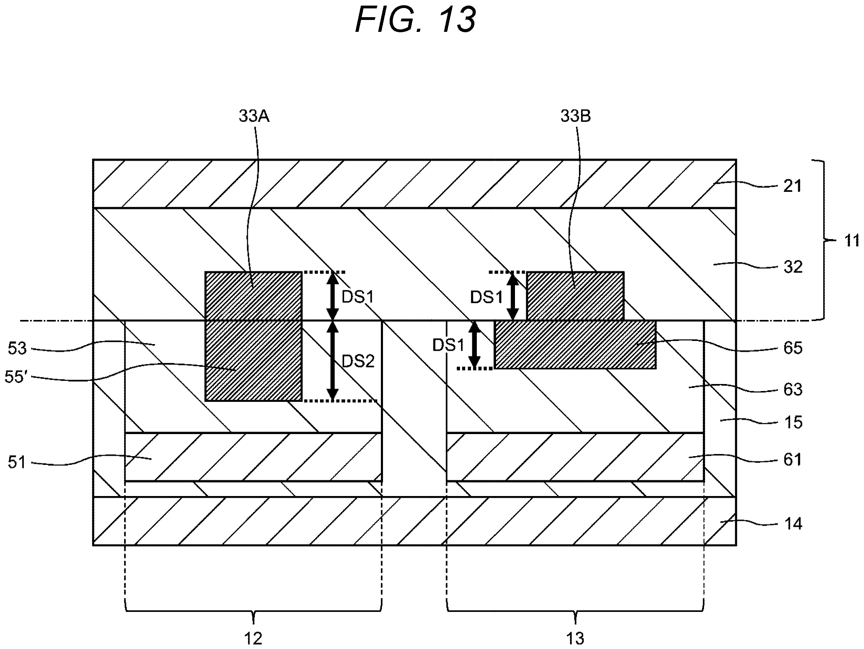

In each modification described with reference to Figs. 13 to 21, for example, description will be given of a bonding electrode structure designed to improve bonding and conductivity between bonding electrodes even in a case where the bonding electrodes are subjected to miniaturization or fine-pitching as described above. The structure of the bonding electrode of the first embodiment described with reference to Figs. 1 and 2 is referred to as basic structure of the bonding electrode of the first embodiment.

Note that, in each of the cross-sectional views of Figs. 13 to 19 for describing the corresponding modification, of the overall configuration of the imaging device 1, a pair of bonding electrodes 33A and 55 by which the first semiconductor 11 and the second semiconductor 12 are bonded, and a pair of bonding electrodes 33B and 65 by which the first semiconductor 11 and the third semiconductor 13 are bonded are highlighted and enlarged, and the other configurations will be described using selectively omitted cross-sectional views.

### <First modification>

Fig. 13 is a cross-sectional view of a first modification of the bonding electrode according to the first embodiment.

The first modification depicted in Fig. 13 is different in that the bonding electrode 55 of the second semiconductor 12 based on the basic structure of the bonding electrode of the first embodiment is changed to a bonding electrode 55', and the other configurations are common.

In the first modification, a thicknesses in a substrate depth direction of the bonding electrodes 33A and 33B of the first semiconductor 11 is DS1 (> 0), a thickness in the substrate depth direction of the bonding electrode 55' of the second semiconductor 12 is DS2 (> DS1) larger than DS1, and a thickness in the substrate depth direction of the bonding electrode 65 of the third semiconductor 12 is DS1.

In the basic structure of the bonding electrode of the first embodiment depicted in Figs. 1 and 2, the bonding electrodes 33A and 33B of the first semiconductor 11, the bonding electrode 55 of the second semiconductor 12, and the bonding electrode 65 of the third semiconductor 12 are formed with the same thickness in the substrate depth direction. In other words, the thickness in the substrate depth direction of the bonding electrode 55 of the second semiconductor 12 is DS1 that is the same as the thicknesses of the bonding electrodes 33A and 33B of the first semiconductor 11 and the bonding electrode 65 of the third semiconductor 12.

In the bonding electrode structure according to the first modification, the thickness of the bonding electrode 33A of the first semiconductor 11 is DS1, and the thickness of the bonding electrode 55' of the second semiconductor 12 is DS2 larger than DS1. That is, the thickness in the substrate depth direction of the bonding electrode is different between the bonding electrode 33A of the first semiconductor 11 and the bonding electrode 55' of the second semiconductor 12. Since the thickness DS2 of the bonding electrode 55' of the second semiconductor 12 subjected to miniaturization and fine-pitching is made larger than the thickness DS1 of the bonding electrode 65 of the third semiconductor 12, it is possible to increase the volume of the bonding electrode 55'. It is therefore possible to increase the amount of thermal expansion of the bonding electrode 55' at the time of bonding, and it is possible to improve bonding and conductivity between the bonding electrode 33A and the bonding electrode 55'.

### <Second modification>

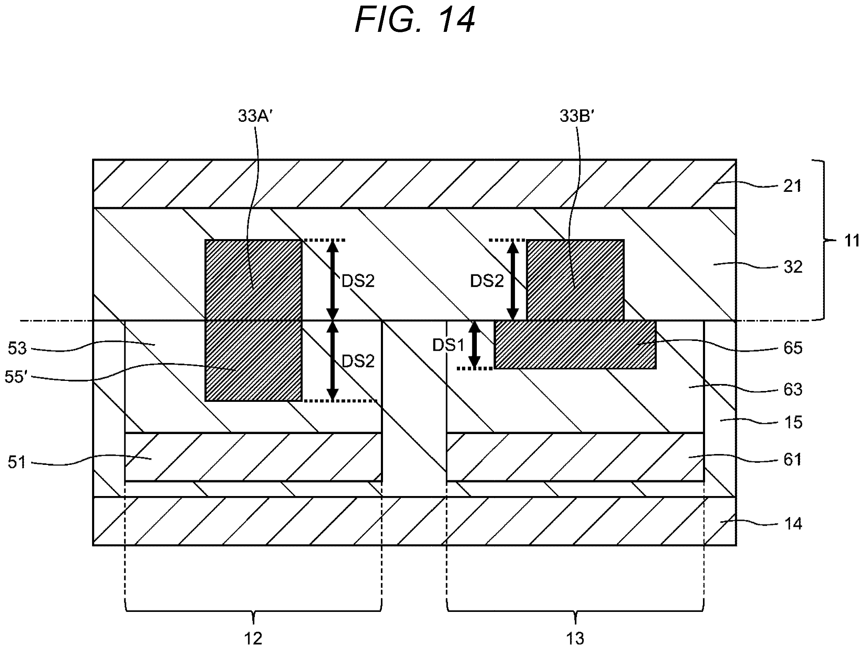

Fig. 14 is a cross-sectional view of a second modification of the bonding electrode according to the first embodiment.

The second modification depicted in Fig. 14 is different in that the bonding electrodes 33A and 33B of the first semiconductor 11 and the bonding electrode 55 of the second semiconductor 12 based on the basic structure of the bonding electrode of the first embodiment are changed to bonding electrodes 33A' and 33B' and a bonding electrode 55', and the other configurations are common.

In the second modification, a thickness in the substrate depth direction of each of the bonding electrodes 33A' and 33B' of the first semiconductor 11 and the bonding electrode 55' of the second semiconductor 12 is DS2 (> 0), and a thickness in the substrate depth direction of the bonding electrode 65 of the third semiconductor 12 is DS1 (< DS2) smaller than DS2.

In the bonding electrode structure according to the second modification, the thickness in the substrate depth direction of each of the bonding electrodes 33A' and 33B' of the first semiconductor 11 and the bonding electrode 55' of the second semiconductor 12 is DS2, and the thickness of the bonding electrode 65 of the third semiconductor 13 is DS1 smaller than DS2. That is, the thickness in the substrate depth direction of the bonding electrode is configured so that the bonding electrode 33A' of the first semiconductor 11 and the bonding electrode 55' of the second semiconductor 12 have the same thickness, and the bonding electrode 33B' of the first semiconductor 11 and the bonding electrode 65' of the third semiconductor 13 have different thicknesses. Since the thickness DS2 in the substrate depth direction of each of the bonding electrodes 33A' and 33B' of the first semiconductor 11 and the bonding electrode 55' of the second semiconductor 12 subjected to miniaturization and fine-pitching is made larger than the thickness DS1 of the bonding electrode 65 of the third semiconductor 12, it is possible to increase the volume of each of the bonding electrodes 33A', 33B', and 55'. It is therefore possible to increase the amount of thermal expansion of each of the bonding electrodes 33A', 33B', and 55' at the time of bonding, and it is possible to improve bonding and conductivity between the bonding electrode 33A' and the bonding electrode 55' and bonding and conductivity between the bonding electrode 33B' and the bonding electrode 65.

The first modification depicted in Fig. 13 has a configuration where only the bonding electrode 55' of the second semiconductor 12, which is one of the bonding electrode 33A of the first semiconductor 11 and the bonding electrode 55' of the second semiconductor 12 bonded after being subjected to miniaturization, is increased in bonding electrode volume. On the other hand, the second modification depicted in Fig. 14 has a configuration where both the bonding electrode 33A' of the first semiconductor 11 and the bonding electrode 55' of the second semiconductor 12 are increased in bonding electrode volume.

### <Third modification>

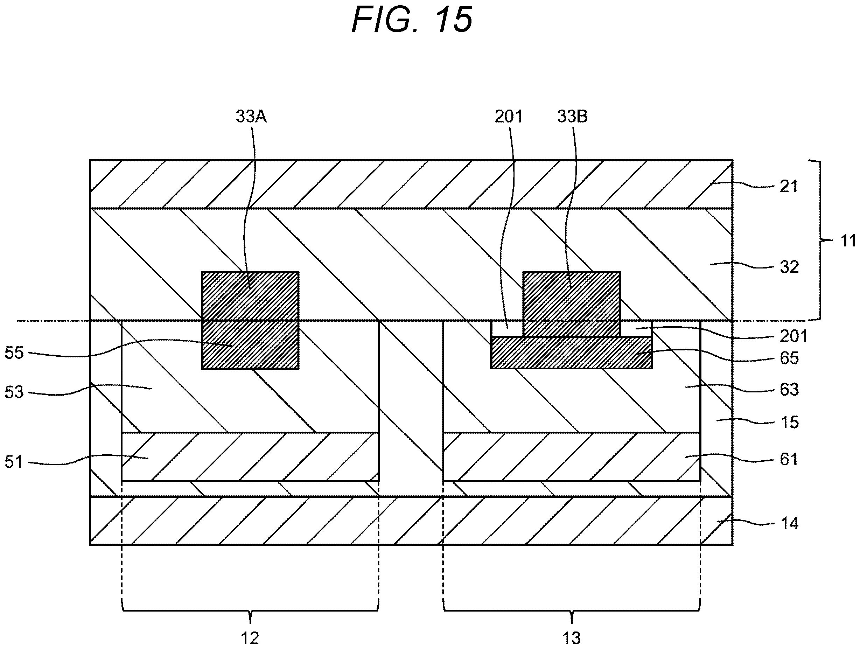

Fig. 15 is a cross-sectional view of a third modification of the bonding electrode according to the first embodiment.

The third modification depicted in Fig. 15 is different in that a gap 201 is provided around the bonded portion (bonding interface) between the bonding electrode 33B of the first semiconductor 11 and the bonding electrode 65 of the third semiconductor 13 based on the basic structure of the bonding electrode of the first embodiment, and the other configurations are common. The bonding interface between the bonding electrode 33B and the bonding electrode 65 is formed on the third semiconductor 13 side relative to the bonding interface between the first semiconductor 11 and the second semiconductor 12.

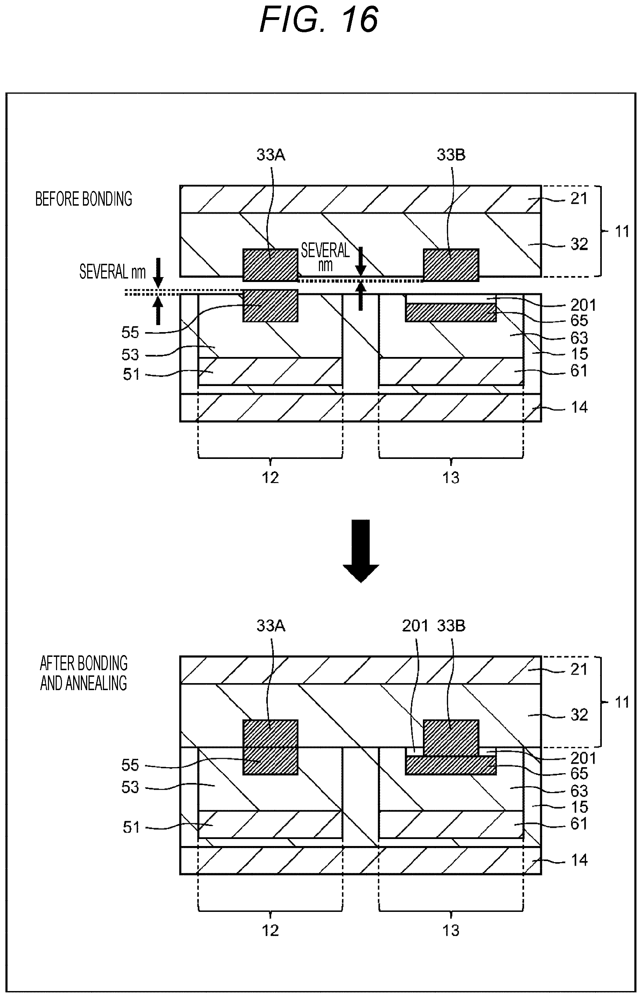

The structure of the third modification having the gap 201 is formed by a manufacturing method depicted in Fig. 16. That is, as depicted in the upper part of Fig. 16, before the first semiconductor 11, and the second semiconductor 12 and the third semiconductor 13 are bonded, in order to compensate for an insufficient amount of thermal expansion at the time of bonding, a process is performed to cause the bonding electrodes 33A, 33B, and 55 smaller in planar size to stick out over the insulating layers 32 and 53 by about several nm. On the other hand, a process is performed to make the bonding electrode 65 larger in planar size than the bonding electrode 33B lower than the upper surface of the insulating layer 63 by about several nm. Then, as depicted in the lower part of Fig. 16, when the CuCu bonding of the bonding electrodes, the oxide film bonding of the insulating layers, and annealing treatment are performed, a structure is obtained in which the gap 201 remains around the bonding interface between the bonding electrode 33B of the first semiconductor 11 and the bonding electrode 65 of the third semiconductor 13. Note that, in the manufacturing method described with reference to Fig. 5, the support substrate 14 and the insulating layer 15 are bonded together after the first semiconductor 11 is bonded to the second semiconductor 12 and the third semiconductor 13, but in the manufacturing method in Fig. 16, the support substrate 14 and the insulating layer 15 are first bonded to the second semiconductor 12 and the third semiconductor 13, and are then bonded with the first semiconductor 11.

In the structure of the bonding electrode of the third modification, it is possible to prevent insufficient bonding due to an insufficient amount of thermal expansion at the time of bonding of the bonding electrode 33A of the first semiconductor 11 and the bonding electrode 55 of the second semiconductor 12, which are arranged after being subjected to miniaturization and fine-pitching, and it is possible to improve bonding and conductivity between the bonding electrode 33A and the bonding electrode 55. The bonding between the bonding electrode 33B of the first semiconductor 11 and the bonding electrode 65 of the third semiconductor 13 can also be performed without any problem.

### <Fourth modification>

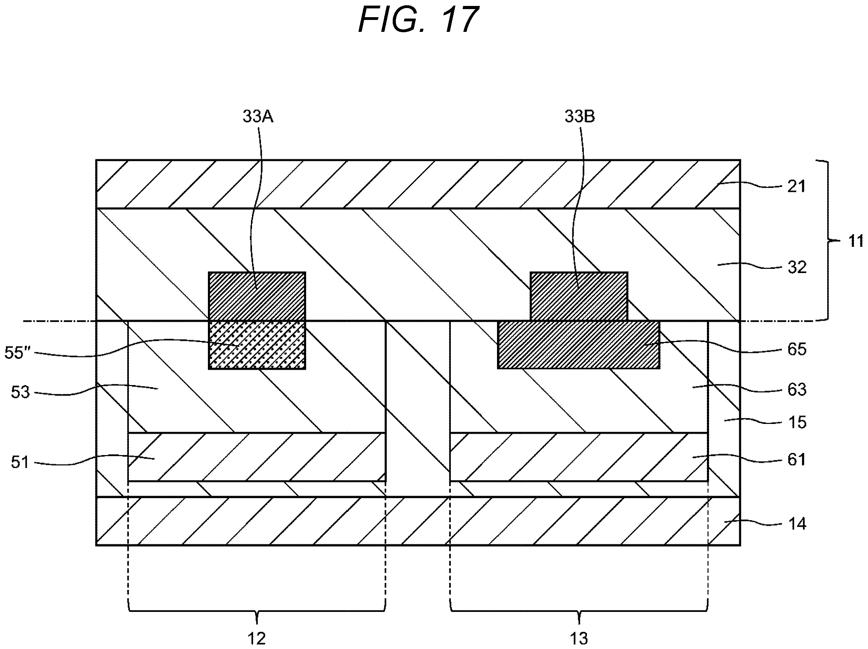

Fig. 17 is a cross-sectional view of a fourth modification of the bonding electrode according to the first embodiment.

The fourth modification depicted in Fig. 17 is different in that the bonding electrode 55 of the second semiconductor 12 based on the basic structure of the bonding electrode of the first embodiment is changed to a bonding electrode 55", and the other configurations are common. The bonding electrode 55" is configured to be higher than the bonding electrodes 33A and 33B of the first semiconductor 11 and the bonding electrode 65 of the third semiconductor 12 in concentration of impurities (impurity concentration) contained in the metal material such as Cu. Examples of the impurities contained in the bonding electrode 55" include carbon (C), nitrogen (N), chlorine (Cl), and sulfur (S). The number of types of impurities contained in the bonding electrode 55" is not necessarily one, and may be two or more.

While the bonding electrodes 33A, 33B, 55, and 65 based on the basic structure of the first embodiment also contain impurities, the bonding electrodes 33A, 33B, 55, and 65 have the same impurity concentration (including variations that can be regarded as approximately the same, even if the impurity concentrations are not exactly the same), and the bonding electrodes 33A, 33B, 55, and 65 are not configured to be intentionally higher in impurity concentration.

In the bonding electrode structure according to the fourth modification, since the concentration of impurities contained in the bonding electrode 55" of the second semiconductor 12 is higher than the impurity concentration of the bonding electrodes 33A and 33B of the first semiconductor 11 and the bonding electrode 65 of the third semiconductor 12, the amount of thermal expansion of the bonding electrode 55" at the time of bonding can be increased. It is therefore possible to improve bonding and conductivity between the bonding electrode 33A and the bonding electrode 55".

### <Fifth modification>

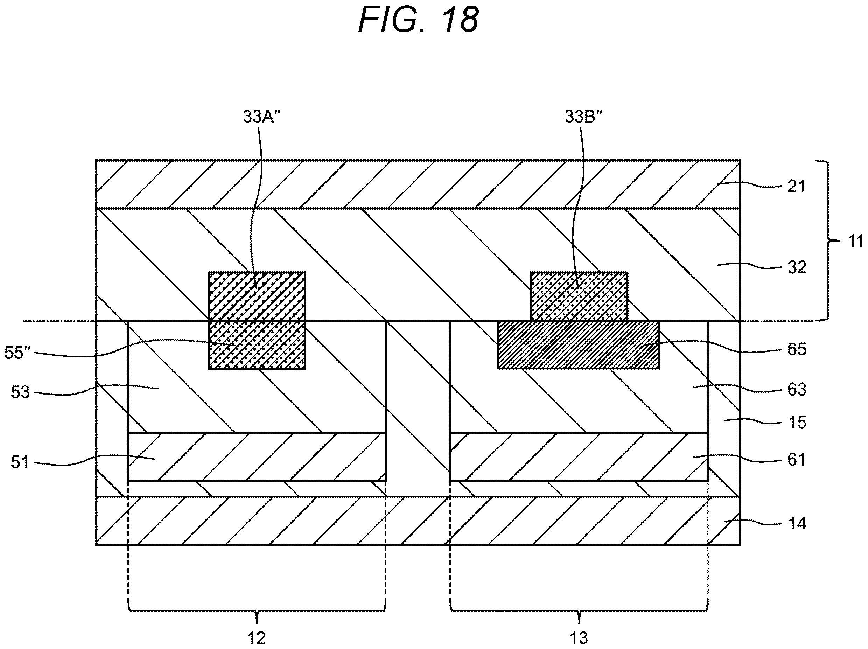

Fig. 18 is a cross-sectional view of a fifth modification of the bonding electrode according to the first embodiment.

The fifth modification depicted in Fig. 18 is different in that the bonding electrodes 33A and 33B of the first semiconductor 11 and the bonding electrode 55 of the second semiconductor 12 based on the basic structure of the bonding electrode of the first embodiment are changed to bonding electrodes 33A", 33B" and 55", and the other configurations are common. As compared with the fourth modification depicted in Fig. 17, the bonding electrodes 33A and 33B of the first semiconductor 11 are changed to the bonding electrodes 33A" and 33B" in the fifth modification.

The bonding electrodes 33A" and 33B" of the first semiconductor 11 are configured to be higher than the bonding electrode 65 of the third semiconductor 12 in concentration of impurities contained in the metal material, in a manner similar to the bonding electrode 55" of the second semiconductor 12. The impurity concentrations of the bonding electrodes 33A" and 33B" of the first semiconductor 11 and the bonding electrode 55" of the second semiconductor 12 may be the same or different, and are only required to be higher than the impurity concentration of the bonding electrode 65. The material of impurities contained in the bonding electrodes 33A" and 33B" is similar to the material of impurities contained in the bonding electrode 55".

In the bonding electrode structure according to the fifth modification, since the concentration of impurities contained in the bonding electrode 33A", 33B", and 55" is made higher than the impurity concentration of the bonding electrode 65 of the third semiconductor 12, the amount of thermal expansion of the bonding electrodes 33A", 33B", and 55" at the time of bonding can be increased. It is therefore possible to improve bonding and conductivity between the bonding electrode 33A" and the bonding electrode 55", and bonding and conductivity between the bonding electrode 33B" and the bonding electrode 65.

Although not depicted, it is also possible to employ a configuration where the bonding electrode 55" of the second semiconductor 12 is replaced with the bonding electrode 55 based on the basic structure similar in impurity concentration to the bonding electrode 65 of the third semiconductor 12, and only the bonding electrode 33 (33A", 33B") of the first semiconductor 11 is made higher in impurity concentration than the bonding electrode 65 of the third semiconductor 12.

According to the fourth modification and the fifth modification, the impurity concentration of at least one of the bonding electrodes 33A" and 33B" of the first semiconductor 11 or the bonding electrode 55" of the second semiconductor 12 formed with a smaller planar size and a finer pitch is only required to be higher than the impurity concentration of the bonding electrode 65 of the third semiconductor 12.

### <Sixth modification>

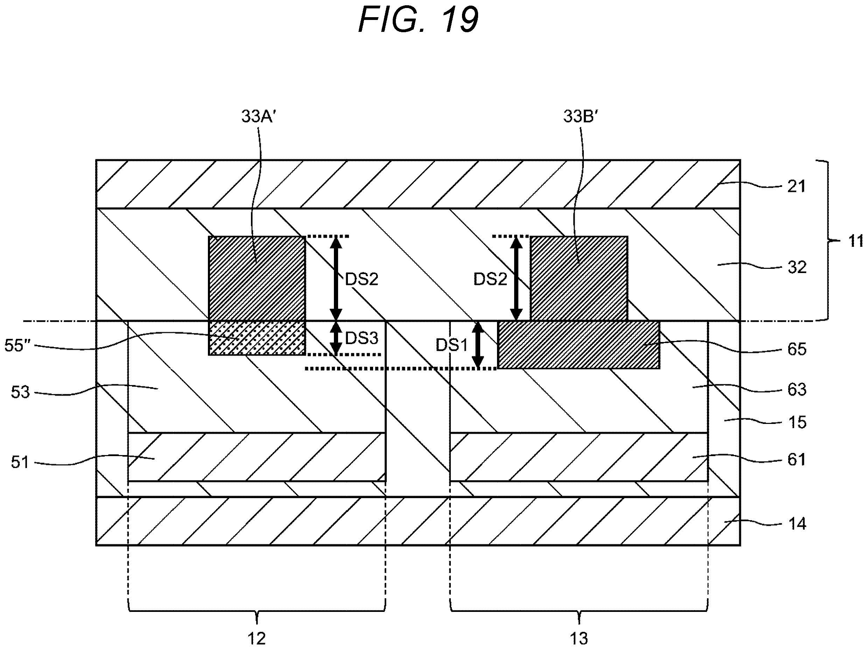

Fig. 19 is a cross-sectional view of a sixth modification of the bonding electrode according to the first embodiment.

The sixth modification depicted in Fig. 19 is different in that the bonding electrodes 33A and 33B of the first semiconductor 11 and the bonding electrode 55 of the second semiconductor 12 based on the basic structure of the bonding electrode of the first embodiment are changed to bonding electrodes 33A' and 33B' and a bonding electrode 55", and the other configurations are common.

In the sixth modification, a thicknesses in the substrate depth direction of the bonding electrodes 33A' and 33B' of the first semiconductor 11 is DS2, a thickness in the substrate depth direction of the bonding electrode 55" of the second semiconductor 12 is DS3, and a thickness in the substrate depth direction of the bonding electrode 65 of the third semiconductor 12 is DS1. Here, the thicknesses DS1, DS2, and DS3 have the following relationship: DS3 < DS1 < DS2.

That is, in the sixth modification, the thickness in the substrate depth direction of the bonding electrodes 33A' and 33B' of the first semiconductor 11 arranged after being subjected to miniaturization and fine-pitching is made larger than thickness in the substrate depth direction of the bonding electrode 65 of the third semiconductor 12 (is set to DS2 larger than DS1), in a manner similar to the second modification, so as to improve bonding and conductivity between the bonding electrodes 33A' and 33B'. On the other hand, the bonding electrode 55" of the second semiconductor 12 arranged after being subjected to miniaturization and fine-pitching is made higher than the bonding electrode 65 of the third semiconductor 12 in concentration of impurities contained in the metal material of the bonding electrode to increase the amount of thermal expansion, in a manner similar to the fourth modification, so as to improve bonding and the conductivity of the bonding electrode 55". It is therefore possible to improve bonding and conductivity between the bonding electrode 33A' and the bonding electrode 55", and it is also possible to improve bonding and conductivity between the bonding electrode 33B' and the bonding electrode 65.

The sixth modification also has the characteristic of the first modification that the thickness in the substrate depth direction of the bonding electrode is different between the bonding electrode 33A' of the first semiconductor 11 and the bonding electrode 55" of the second semiconductor 12. Note that, in the structure of the first modification depicted in Fig. 13, the bonding electrode 55' of the second semiconductor 12 is formed to be larger in thickness than the bonding electrode 33A of the first semiconductor 11, whereas in the sixth modification, the bonding electrode 55" of the second semiconductor 12 is formed to be smaller in thickness than the bonding electrode 33A' of the first semiconductor 11. In a case where the volume is increased by an increase in thickness of the bonding electrode for the purpose of improving bonding and conductivity, there is a concern about an increase in wiring capacitance. In a case where it is desired to suppress an increase in wiring capacitance, a configuration where the impurity concentration is increased, and the thickness of the bonding electrode 55" is reduced as in the bonding electrode 55" of the second semiconductor 12 in Fig. 19 may be employed.

The bonding electrode structure of the sixth modification depicted in Fig. 19 corresponds to a configuration where the characteristic of the first modification depicted in Fig. 13, the characteristic of the second modification depicted in Fig. 14, and the characteristic of the fourth modification depicted in Fig. 17 are combined.

### <Seventh modification>

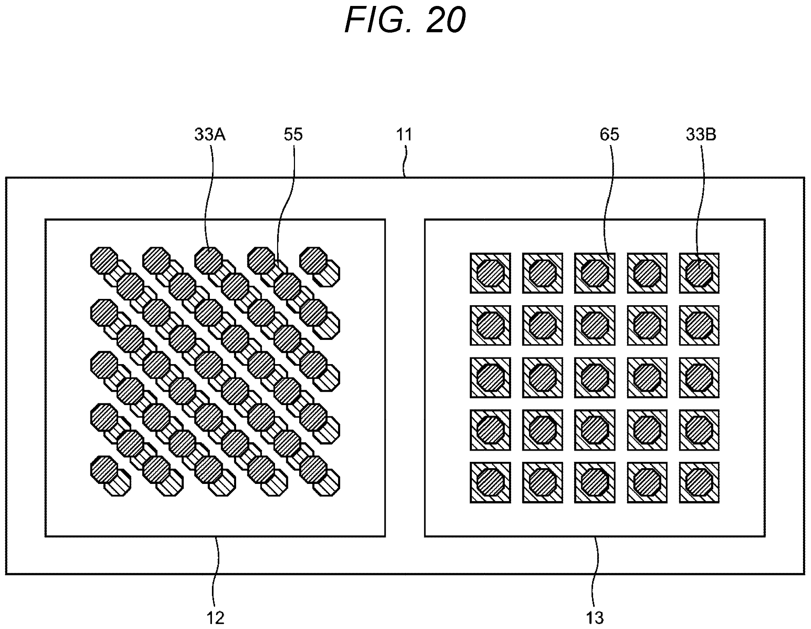

Fig. 20 is a plan view of a seventh modification of the bonding electrode according to the first embodiment.

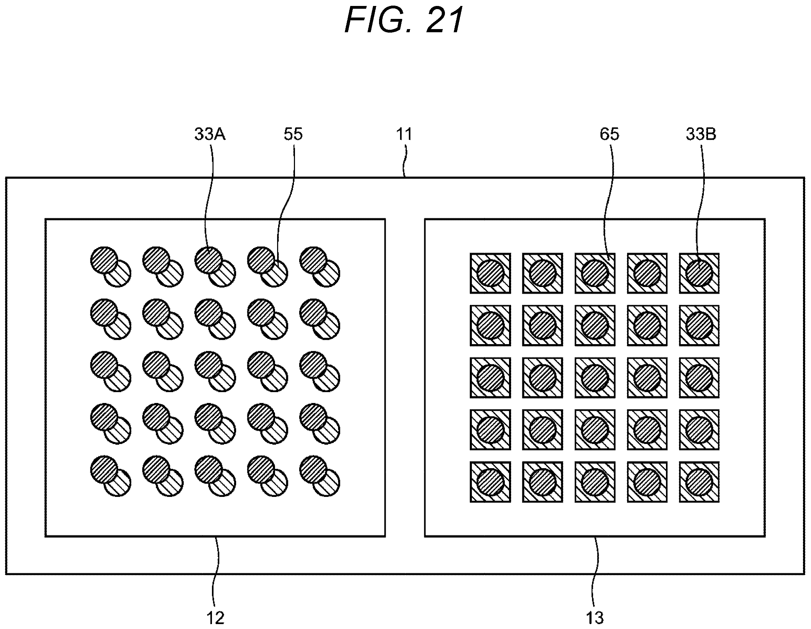

The seventh modification depicted in Figs. 20 and 21 is a modification of the planar shape of the bonding electrode.

In the first embodiment described above, as described with reference to Fig. 2, the bonding electrode 33 (33A, 33B) of the first semiconductor 11, the bonding electrode 55 of the second semiconductor 12, and the bonding electrode 65 of the third semiconductor 13 each have a quadrangular planar shape.

On the other hand, in the seventh modification depicted in Fig. 20, the bonding electrode 33 (33A, 33B) of the first semiconductor 11 and the bonding electrode 55 of the second semiconductor 12 are formed in an octagonal planar shape.

Note that the bonding electrode 33A of the first semiconductor 11 and the bonding electrode 55 of the second semiconductor 12 are formed at positions coincident with each other in plan view as depicted in the cross-sectional view of Fig. 1 and the like, but are shifted from each other in the plan view of Fig. 20 so as to make both the bonding electrode 33A and the bonding electrode 55 recognizable. Furthermore, in the cross-sectional view of Fig. 1, the bonding electrodes 33A and 33B of the first semiconductor 11, the bonding electrode 55 of the second semiconductor 12, and the bonding electrode 65 of the third semiconductor 13 are depicted in the same pattern (hatching), but in the plan view of Fig. 20, the bonding electrode 55 and the bonding electrode 65 are depicted in patterns different from the pattern in the cross-sectional view in order to make the distinction easier.

As described above, the bonding electrodes 33A and 33B of the first semiconductor 11 and the bonding electrode 55 of the second semiconductor 12 may each have a polygonal planar shape larger than a quadrangular planar shape. Alternatively, as depicted in Fig. 21, the bonding electrodes 33A and 33B of the first semiconductor 11 and the bonding electrode 55 of the second semiconductor 12 may each have a circular planar shape. When at least one of the bonding electrode 33 (33A, 33B) of the first semiconductor 11 or the bonding electrode 55 of the second semiconductor 12 has a polygonal planar shape or circular planar shape larger than a quadrangular planar shape, the arrangement pitch of the bonding electrodes can be reduced, and the bonding electrodes can be densely arranged accordingly. It is therefore possible to improve flatness during chemical mechanical polishing (CMP) processing. Furthermore, with the bonding electrodes formed in a polygonal planar shape or circular planar shape, even in a case where a misalignment occurs between upper and lower bonding electrodes, it is possible to make a region where the upper and lower bonding electrodes overlap each other large as compared with a quadrangular planar shape. It is therefore possible to reduce the impact of a bonding misalignment.

Figs. 20 and 21 depicts examples where both the bonding electrode 33 (33A, 33B) of the first semiconductor 11 and the bonding electrode 55 of the second semiconductor 12 have a polygonal planar shape or circular planar shape, but at least one of the bonding electrode 33 of the first semiconductor 11 or the bonding electrode 55 of the second semiconductor 12 may have a polygonal planar shape or circular planar shape. Furthermore, an example of the octagonal planar shape has been described as an example of the polygonal planar shape, but any polygonal planar shape larger than a quadrangular planar shape may be used, and for example, a hexagonal planar shape may be used.

The first to seventh modifications of the bonding electrode described above have been described as modifications of the bonding electrode in the first embodiment, but can also be employed as modifications of the bonding electrodes in the second to fourth embodiments.

### <7. Usage example of imaging device>

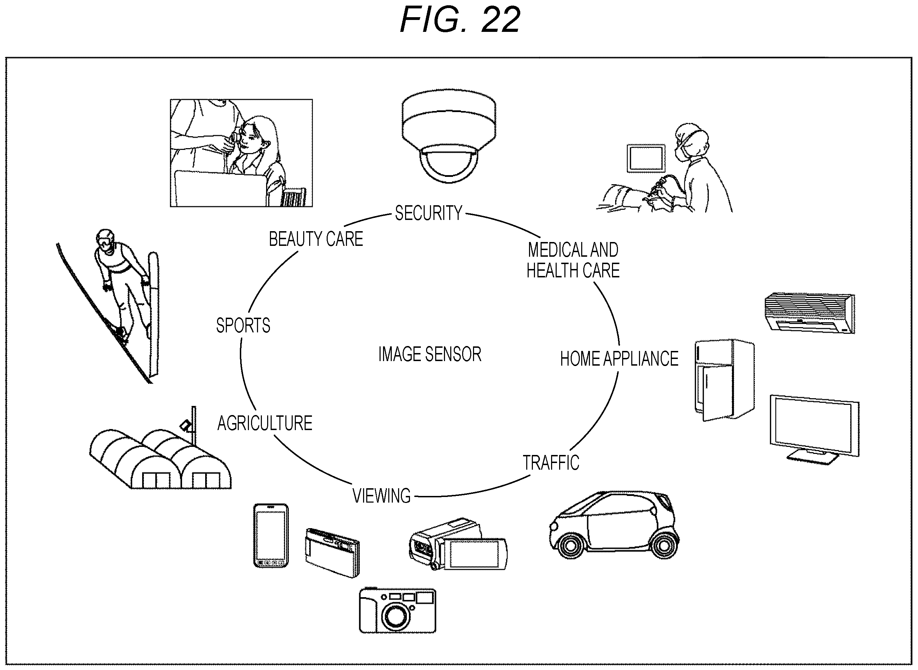

Fig. 22 is a diagram depicting a usage example of an image sensor using the above-described imaging device 1.

The above-described imaging device 1 can be used as an image sensor in various cases of sensing light such as visible light, infrared light, ultraviolet light, and X-rays as described below, for example.

- A device that captures an image to be used for viewing, such as a digital camera and a portable device with a camera function
- A device for traffic purpose such as an in-vehicle sensor that captures images of the front, rear, surroundings, interior and the like of an automobile, a monitoring camera that monitors traveling vehicles and roads, and a distance measuring sensor that measures a distance between vehicles and the like for safe driving such as automatic stop, recognition of a driver's condition and the like
- A device for home appliance such as a television, a refrigerator, and an air conditioner that images a user's gesture and performs device operation according to the gesture
- A device for medical and health care use such as an endoscope and a device that performs angiography by receiving infrared light
- A device for security use such as a security monitoring camera and an individual authentication camera
- A device used for beauty care, such as a skin measuring instrument for imaging skin, and a microscope for imaging the scalp
- A device used for sports, such as an action camera or a wearable camera for sports applications or the like
- A device used for agriculture, such as a camera for monitoring a condition of a field or crop.

### <8. Application example to electronic device>

The present technology is not limited to application to an imaging device. That is, the present technology can be applied to all electronic devices that use an imaging device for an image capture unit (photoelectric conversion element), such as an imaging device such as a digital still camera or video camera, a mobile terminal device having an imaging function, or a copying machine using an imaging device in an image reading unit. The imaging device may be formed as one chip, or may be in a module form having an imaging function in which an imaging unit and a signal processing unit or an optical system are packaged together.

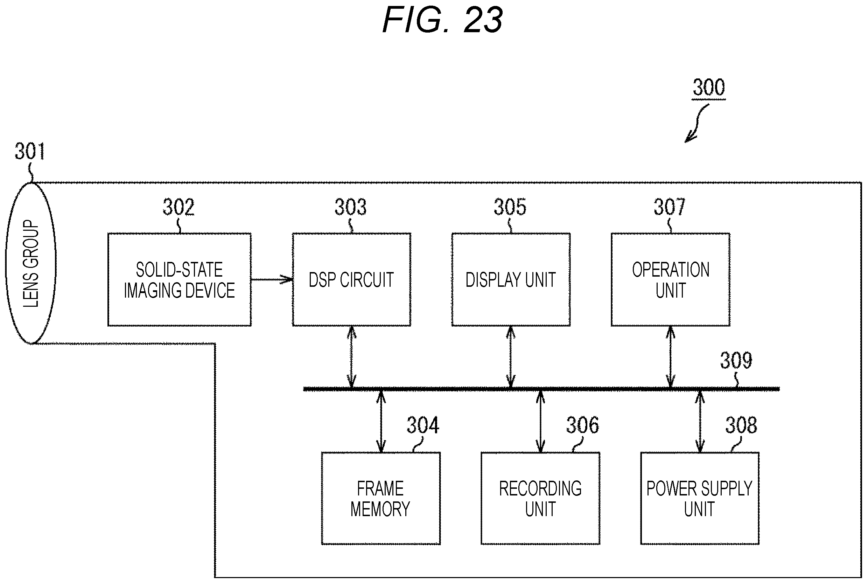

Fig. 23 is a block diagram depicting a configuration example of an electronic device to which the present technology is applied.

An electronic device 300 in Fig. 23 includes an optical unit 301 including a lens group and the like, a solid-state imaging device (imaging device) 302 to which the configuration of the imaging device 1 in Fig. 1 is applied, and a digital signal processor (DSP) circuit 303 that is a camera signal processing circuit. Furthermore, the electronic device 300 further includes a frame memory 304, a display unit 305, a recording unit 306, an operation unit 307, and a power supply unit 308. The DSP circuit 303, the frame memory 304, the display unit 305, the recording unit 306, the operation unit 307, and the power supply unit 308 are connected to one another via a bus line 309.

The optical unit 301 captures incident light (image light) from a subject and forms an image on an imaging surface of the solid-state imaging device 302. The solid-state imaging device 302 converts the light amount of the incident light imaged on the imaging surface by the optical unit 301 into an electrical signal in units of pixels and outputs the electrical signal as a pixel signal. As the solid-state imaging device 302, it is possible to use the imaging device 1 in Fig. 1, that is, an imaging device that includes the first semiconductor 11 as a main substrate, and the second semiconductor 12 and the third semiconductor 13, which are semiconductor chips smaller in planar size than the first semiconductor 11, the first semiconductor 11, and the second semiconductor 12 and the third semiconductor 13 being directly bonded together, and in which the bonding electrode 65 of the third semiconductor 13 is formed to be larger in planar size than the bonding electrode 55 of the second semiconductor 12.

For example, the display unit 305 includes a thin display such as a liquid crystal display (LCD) or an organic electro luminescence (EL) display, and displays a moving image or a still image captured by the solid-state imaging device 302. The recording unit 306 records a moving image or a still image captured by the solid-state imaging device 302 on a recording medium such as a hard disk or a semiconductor memory.

The operation unit 307 issues operation commands for various functions of the electronic device 300 in response to an operation performed by a user. The power supply unit 308 appropriately supplies various power to be operation power supply for the DSP circuit 303, the frame memory 304, the display unit 305, the recording unit 306, and the operation unit 307, to these supply targets.

As described above, the use of the imaging device 1 to which any one of the above-described embodiments is applied as the solid-state imaging device 302 allows a reduction in manufacturing cost and an improvement in yield. Therefore, even for the electronic device 300 such as a video camera, a digital still camera, or a camera module for a mobile device such as a mobile phone, the manufacturing cost can be reduced, and the yield can be improved.

### <9. Application example to mobile object>

The technology according to the present disclosure (the present technology) is applicable to various products. For example, the technology according to the present disclosure may be implemented as a device mounted on any type of mobile object such as an automobile, an electric vehicle, a hybrid electric vehicle, a motorcycle, a bicycle, a personal mobility, an airplane, a drone, a ship, a robot, and the like.

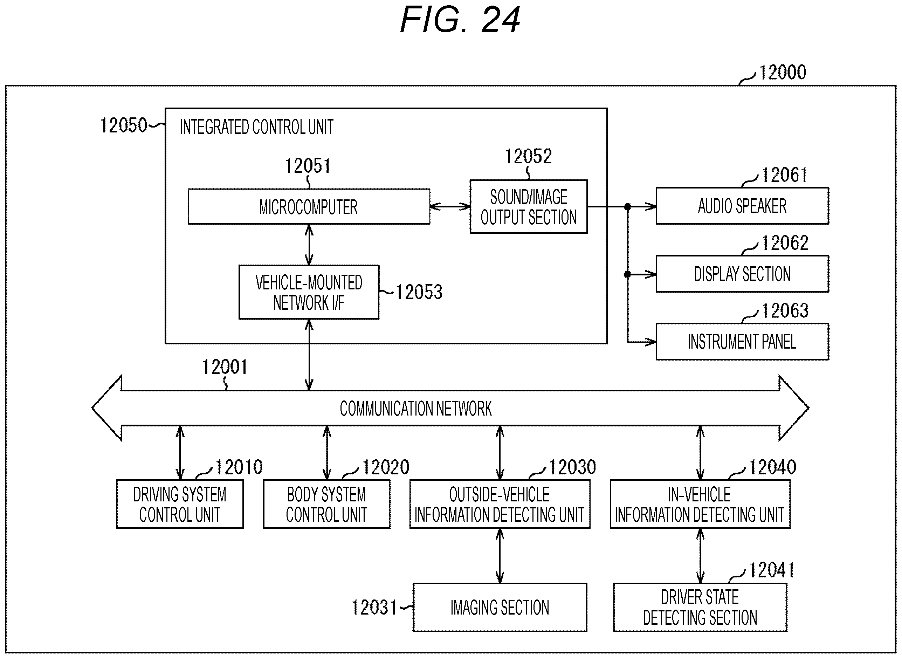

Fig. 24 is a block diagram depicting an example of a schematic configuration of a vehicle control system as an example of a mobile object control system to which the technology according to an embodiment of the present disclosure can be applied.

The vehicle control system 12000 includes a plurality of electronic control units connected to each other via a communication network 12001. In the example depicted in Fig. 24, the vehicle control system 12000 includes a driving system control unit 12010, a body system control unit 12020, an outside-vehicle information detecting unit 12030, an in-vehicle information detecting unit 12040, and an integrated control unit 12050. Furthermore, a microcomputer 12051, a sound/image output section 12052, and a vehicle-mounted network interface (I/F) 12053 are depicted as functional components of the integrated control unit 12050.

The driving system control unit 12010 controls the operation of devices related to the driving system of the vehicle in accordance with various kinds of programs. For example, the driving system control unit 12010 functions as a control device for a driving force generating device for generating the driving force of the vehicle, such as an internal combustion engine, a driving motor, or the like, a driving force transmitting mechanism for transmitting the driving force to wheels, a steering mechanism for adjusting the steering angle of the vehicle, a braking device for generating the braking force of the vehicle, and the like.

The body system control unit 12020 controls the operation of various kinds of devices provided to a vehicle body in accordance with various kinds of programs. For example, the body system control unit 12020 functions as a control device for a keyless entry system, a smart key system, a power window device, or various kinds of lamps such as a headlamp, a backup lamp, a brake lamp, a turn signal, a fog lamp, or the like. In this case, radio waves transmitted from a mobile device as an alternative to a key or signals of various kinds of switches can be input to the body system control unit 12020. The body system control unit 12020 receives these input radio waves or signals, and controls a door lock device, the power window device, the lamps, or the like of the vehicle.

The outside-vehicle information detecting unit 12030 detects information about the outside of the vehicle including the vehicle control system 12000. For example, the outside-vehicle information detecting unit 12030 is connected with an imaging section 12031. The outside-vehicle information detecting unit 12030 makes the imaging section 12031 image an image of the outside of the vehicle, and receives the imaged image. On the basis of the received image, the outside-vehicle information detecting unit 12030 may perform processing of detecting an object such as a human, a vehicle, an obstacle, a sign, a character on a road surface, or the like, or processing of detecting a distance thereto.

The imaging section 12031 is an optical sensor that receives light, and which outputs an electric signal corresponding to a received light amount of the light. The imaging section 12031 can output the electric signal as an image, or can output the electric signal as information about a measured distance. In addition, the light received by the imaging section 12031 may be visible light, or may be invisible light such as infrared rays or the like.

The in-vehicle information detecting unit 12040 detects information about the inside of the vehicle. The in-vehicle information detecting unit 12040 is, for example, connected with a driver state detecting section 12041 that detects the state of a driver. The driver state detecting section 12041, for example, includes a camera that images the driver. On the basis of detection information input from the driver state detecting section 12041, the in-vehicle information detecting unit 12040 may calculate a degree of fatigue of the driver or a degree of concentration of the driver, or may determine whether the driver is dozing.

The microcomputer 12051 can calculate a control target value for the driving force generating device, the steering mechanism, or the braking device on the basis of the information about the inside or outside of the vehicle which information is obtained by the outside-vehicle information detecting unit 12030 or the in-vehicle information detecting unit 12040, and output a control command to the driving system control unit 12010. For example, the microcomputer 12051 can perform cooperative control intended to implement functions of an advanced driver assistance system (ADAS) which functions include collision avoidance or shock mitigation for the vehicle, following driving based on a following distance, vehicle speed maintaining driving, a warning of collision of the vehicle, a warning of deviation of the vehicle from a lane, or the like.

In addition, the microcomputer 12051 can perform cooperative control intended for automated driving, which makes the vehicle to travel automatedly without depending on the operation of the driver, or the like, by controlling the driving force generating device, the steering mechanism, the braking device, or the like on the basis of the information about the outside or inside of the vehicle which information is obtained by the outside-vehicle information detecting unit 12030 or the in-vehicle information detecting unit 12040.

Furthermore, the microcomputer 12051 can output a control command to the body system control unit 12020 on the basis of the information about the outside of the vehicle, the information being obtained by the outside-vehicle information detecting unit 12030. For example, the microcomputer 12051 can perform cooperative control intended to prevent a glare by controlling the headlamp so as to change from a high beam to a low beam, for example, in accordance with the position of a preceding vehicle or an oncoming vehicle detected by the outside-vehicle information detecting unit 12030.

The sound/image output section 12052 transmits an output signal of at least one of a sound and an image to an output device capable of visually or auditorily notifying information to an occupant of the vehicle or the outside of the vehicle. In the example in Fig. 24, an audio speaker 12061, a display section 12062, and an instrument panel 12063 are depicted as the output device. The display section 12062 may, for example, include at least one of an on-board display and a head-up display.

Fig. 25 is a diagram depicting an example of the installation position of the imaging section 12031.

In Fig. 25, a vehicle 12100 includes imaging sections 12101, 12102, 12103, 12104, and 12105, as the imaging section 12031.

The imaging sections 12101, 12102, 12103, 12104, and 12105 are provided, for example, at positions such as a front nose, a sideview mirror, a rear bumper, a back door, and an upper portion of a windshield within the interior of the vehicle 12100. The imaging section 12101 provided to the front nose and the imaging section 12105 provided to the upper portion of the windshield within the interior of the vehicle obtain mainly an image of the front of the vehicle 12100. The imaging sections 12102 and 12103 provided on the sideview mirrors obtain mainly an image of the sides of the vehicle 12100. The imaging section 12104 provided to the rear bumper or the back door obtains mainly an image of the rear of the vehicle 12100. The forward images obtained by the imaging sections 12101 and 12105 are used mainly to detect a preceding vehicle, a pedestrian, an obstacle, a traffic light, a traffic sign, a lane, or the like.

Note that Fig. 25 depicts an example of imaging ranges of the imaging sections 12101 to 12104. An imaging range 12111 represents the imaging range of the imaging section 12101 provided to the front nose. Imaging ranges 12112 and 12113 respectively represent the imaging ranges of the imaging sections 12102 and 12103 provided to the sideview mirrors. An imaging range 12114 represents the imaging range of the imaging section 12104 provided to the rear bumper or the back door. A bird's-eye image of the vehicle 12100 as viewed from above is obtained by superimposing image data imaged by the imaging sections 12101 to 12104, for example.

At least one of the imaging sections 12101 to 12104 may have a function of obtaining distance information. For example, at least one of the imaging sections 12101 to 12104 may be a stereo camera constituted of a plurality of imaging elements, or may be an imaging element having pixels for phase difference detection.

For example, the microcomputer 12051 can determine a distance to each three-dimensional object within the imaging ranges 12111 to 12114 and a temporal change in the distance (relative speed with respect to the vehicle 12100) on the basis of the distance information obtained from the imaging sections 12101 to 12104, and thereby extract, as a preceding vehicle, a nearest three-dimensional object in particular that is present on a traveling path of the vehicle 12100 and which travels in substantially the same direction as the vehicle 12100 at a predetermined speed (for example, equal to or more than 0 km/hour). Further, the microcomputer 12051 can set a following distance to be maintained in front of a preceding vehicle in advance, and perform automatic brake control (including following stop control), automatic acceleration control (including following start control), or the like. It is thus possible to perform cooperative control intended for automated driving that makes the vehicle travel automatedly without depending on the operation of the driver or the like.

For example, the microcomputer 12051 can classify three-dimensional object data on three-dimensional objects into three-dimensional object data of a two-wheeled vehicle, a standard-sized vehicle, a large-sized vehicle, a pedestrian, a utility pole, and other three-dimensional objects on the basis of the distance information obtained from the imaging sections 12101 to 12104, extract the classified three-dimensional object data, and use the extracted three-dimensional object data for automatic avoidance of an obstacle. For example, the microcomputer 12051 identifies obstacles around the vehicle 12100 as obstacles that the driver of the vehicle 12100 can recognize visually and obstacles that are difficult for the driver of the vehicle 12100 to recognize visually. Then, the microcomputer 12051 determines a collision risk indicating a risk of collision with each obstacle. In a situation in which the collision risk is equal to or higher than a set value and there is thus a possibility of collision, the microcomputer 12051 outputs a warning to the driver via the audio speaker 12061 or the display section 12062, and performs forced deceleration or avoidance steering via the driving system control unit 12010. The microcomputer 12051 can thereby assist in driving to avoid collision.

At least one of the imaging sections 12101 to 12104 may be an infrared camera that detects infrared rays. The microcomputer 12051 can, for example, recognize a pedestrian by determining whether or not there is a pedestrian in imaged images of the imaging sections 12101 to 12104. Such recognition of a pedestrian is, for example, performed by a procedure of extracting characteristic points in the imaged images of the imaging sections 12101 to 12104 as infrared cameras and a procedure of determining whether or not it is the pedestrian by performing pattern matching processing on a series of characteristic points representing the contour of the object. When the microcomputer 12051 determines that there is a pedestrian in the imaged images of the imaging sections 12101 to 12104, and thus recognizes the pedestrian, the sound/image output section 12052 controls the display section 12062 so that a square contour line for emphasis is displayed so as to be superimposed on the recognized pedestrian. The sound/image output section 12052 may also control the display section 12062 so that an icon or the like representing the pedestrian is displayed at a desired position.

An example of the vehicle control system to which the technology according to the present disclosure can be applied has been described above. The technology of the present disclosure can be applied to the imaging section 12031 among the configurations described above. Specifically, the imaging device 1 according to each of the above-described embodiments can be applied as the imaging section 12031. By applying the technology according to the present disclosure to the imaging section 12031, it is possible to obtain a more easily-viewed captured image and obtain distance information while reducing the manufacturing cost and the size. Furthermore, it is possible to reduce driver's fatigue and increase the safety of the driver and the vehicle by using the obtained captured image and distance information.

Furthermore, the present disclosure is not limited to application to a solid-state imaging device that detects distribution of the amount of incident light of visible light and captures the distribution as an image, and can be applied to all solid-state imaging devices (physical quantity distribution detection devices) such as a solid-state imaging device that captures distribution of the amount of incident infrared rays, X-rays, particles, or the like as an image, and a fingerprint detection sensor that detects distribution of other physical quantities such as pressure and capacitance and captures the distribution as an image in a broad sense.

Furthermore, the present technology can be applied not only to solid-state imaging devices but also to general semiconductor devices having other semiconductor integrated circuits.

The embodiment of the present disclosure is not limited to the above-described embodiments, and various modifications can be made without departing from the scope of the present technology.

For example, it is possible to adopt a mode obtained by combining all or some of the plurality of embodiments described above.

Note that, the effects described in the present specification are merely examples and are not limited, and there may be effects other than those described in the present specification.

Note that, the present technology may have the following configurations.
(1) A semiconductor device including:
   a first semiconductor in which a plurality of first bonding electrodes is formed;
   a second semiconductor in which second bonding electrodes each bonded to a corresponding one of the first bonding electrodes are formed, the second semiconductor being smaller in planar size than the first semiconductor; and
   a third semiconductor in which third bonding electrodes each bonded to a corresponding one of the first bonding electrodes are formed, the third semiconductor being smaller in planar size than the first semiconductor, in which
   the second semiconductor and the third semiconductor are bonded to the same surface of the first semiconductor, and
   the third bonding electrodes include electrodes formed to be larger in planar size than the second bonding electrodes.
(2) The semiconductor device according to the above (1), in which
   a plurality of the third bonding electrodes is connected via a predetermined metal wiring and is short-circuited.
(3) The semiconductor device according to the above (1) or (2), in which
   the first semiconductor includes a photoelectric conversion element.
(4) The semiconductor device according to any one of the above (1) to (3), in which
   the first semiconductor has a multilayer structure with two semiconductor substrates stacked on top of each other.
(5) The semiconductor device according to any one of the above (1) to (4), in which
   the second semiconductor includes a logic circuit, the logic circuit including a signal processing circuit or an AI processing circuit.
(6) The semiconductor device according to any one of the above (1) to (5), in which
   the third semiconductor includes a memory circuit.
(7) The semiconductor device according to any one of the above (1) to (6), in which
   one of the third bonding electrodes is bonded to a plurality of the first bonding electrodes.
(8) The semiconductor device according to any one of the above (1) to (7), in which
   the first bonding electrodes are each identical in planar size to a mating bonding electrode.
(9) The semiconductor device according to any one of the above (1) to (8), in which
   the first bonding electrodes bonded to the second bonding electrodes and the first bonding electrodes bonded to the third bonding electrodes are identical in planar size to each other.
(10) The semiconductor device according to any one of the above (1) to (9), in which
   a plurality of the first bonding electrodes bonded to the third bonding electrodes is connected via a predetermined metal wiring and is short-circuited.
(11) The semiconductor device according to any one of the above (1) to (10), in which
   a plurality of the first bonding electrodes and a plurality of the third bonding electrodes include dummy bonding electrodes.
(12) The semiconductor device according to any one of the above (1) to (11), in which
   a bonding electrode thickness in a substrate depth direction is different between the first bonding electrodes and the second bonding electrodes.
(13) The semiconductor device according to any one of the above (1) to (12), in which
   a bonding electrode thickness in a substrate depth direction is different between the first bonding electrodes and the third bonding electrodes.
(14) The semiconductor device according to any one of the above (1) to (13), in which
   the third bonding electrodes are larger in planar size than the first bonding electrodes and each have a gap around a bonded portion between the third bonding electrode and a corresponding one of the first bonding electrodes.
(15) The semiconductor device according to any one of the above (1) to (14), in which
   at least one of a concentration of impurities contained in a metal material of the first bonding electrodes or a concentration of impurities contained in a metal material of the second bonding electrodes is higher than an impurity concentration of the third bonding electrodes.
(16) The semiconductor device according to any one of the above (1) to (15), in which
   at least one of a planar shape of the first bonding electrodes or a planar shape of the second bonding electrodes has a quadrangular planar shape.
(17) The semiconductor device according to any one of the above (1) to (15), in which
   at least one of a planar shape of the first bonding electrodes or a planar shape of the second bonding electrodes has a polygonal planar shape or circular planar shape larger than a quadrangular planar shape.
(18) An imaging device including:
   a first semiconductor in which a plurality of first bonding electrodes is formed;
   a second semiconductor in which second bonding electrodes each bonded to a corresponding one of the first bonding electrodes are formed, the second semiconductor being smaller in planar size than the first semiconductor; and
   a third semiconductor in which third bonding electrodes each bonded to a corresponding one of the first bonding electrodes are formed, the third semiconductor being smaller in planar size than the first semiconductor, in which
   the second semiconductor and the third semiconductor are bonded to a same surface of the first semiconductor, and
   the third bonding electrodes include electrodes formed to be larger in planar size than the second bonding electrodes.

### REFERENCE SIGNS LIST

1 Imaging device
11 First semiconductor
12 Second semiconductor
13 Third semiconductor
14 Support substrate
15 Insulating layer
21 Semiconductor substrate
22 Photodiode
23 Color filter
24 On-chip lens
25 Planarizing film
26 Insulating layer
31, 31E Metal wiring
32 Insulating layer
33, 33A to 33F, 33A', 33B', 33A", 33B"Bonding electrode
34 Pad
35 Through hole
41 Wiring layer
51 Semiconductor substrate
52, 52D Metal wiring
53 Insulating layer
54 Wiring layer
55, 55', 55" Bonding electrode
61 Semiconductor substrate
62, 62C, 62C' Metal wiring
63 Insulating layer
64 Wiring layer
65, 65B, 65C, 65C' Bonding electrode
81 Pixel array unit
82A, 82B Pad portion
91 AD conversion circuit
92 Logic circuit
93 IF circuit
94 Memory circuit
131 Semiconductor substrate
132 Wiring layer
133 Wiring layer
141 Metal wiring
142 Insulating layer
143 Bonding electrode
151, 153B, 153F Metal wiring
152 Insulating layer
161 Through via
201 Gap
300 Electronic device
302 Solid-state imaging device

## Claims

1. A semiconductor device comprising:
a first semiconductor in which a plurality of first bonding electrodes is formed;
a second semiconductor in which second bonding electrodes each bonded to a corresponding one of the first bonding electrodes are formed, the second semiconductor being smaller in planar size than the first semiconductor; and
a third semiconductor in which third bonding electrodes each bonded to a corresponding one of the first bonding electrodes are formed, the third semiconductor being smaller in planar size than the first semiconductor, wherein
the second semiconductor and the third semiconductor are bonded to a same surface of the first semiconductor, and
the third bonding electrodes include electrodes formed to be larger in planar size than the second bonding electrodes.

2. The semiconductor device according to claim 1, wherein
a plurality of the third bonding electrodes is connected via a predetermined metal wiring and is short-circuited.

3. The semiconductor device according to claim 1, wherein
the first semiconductor includes a photoelectric conversion element.

4. The semiconductor device according to claim 1, wherein
the first semiconductor has a multilayer structure with two semiconductor substrates stacked on top of each other.

5. The semiconductor device according to claim 1, wherein
the second semiconductor includes a logic circuit, the logic circuit including a signal processing circuit or an AI processing circuit.

6. The semiconductor device according to claim 1, wherein
the third semiconductor includes a memory circuit.

7. The semiconductor device according to claim 1, wherein
one of the third bonding electrodes is bonded to a plurality of the first bonding electrodes.

8. The semiconductor device according to claim 1, wherein
the first bonding electrodes are each identical in planar size to a mating bonding electrode.

9. The semiconductor device according to claim 1, wherein
the first bonding electrodes bonded to the second bonding electrodes and the first bonding electrodes bonded to the third bonding electrodes are identical in planar size to each other.

10. The semiconductor device according to claim 1, wherein
a plurality of the first bonding electrodes bonded to the third bonding electrodes is connected via a predetermined metal wiring and is short-circuited.

11. The semiconductor device according to claim 1, wherein
a plurality of the first bonding electrodes and a plurality of the third bonding electrodes include dummy bonding electrodes.

12. The semiconductor device according to claim 1, wherein
a bonding electrode thickness in a substrate depth direction is different between the first bonding electrodes and the second bonding electrodes.

13. The semiconductor device according to claim 1, wherein
a bonding electrode thickness in a substrate depth direction is different between the first bonding electrodes and the third bonding electrodes.

14. The semiconductor device according to claim 1, wherein
the third bonding electrodes are larger in planar size than the first bonding electrodes and each have a gap around a bonded portion between the third bonding electrode and a corresponding one of the first bonding electrodes.

15. The semiconductor device according to claim 1, wherein
at least one of an impurity concentration of the first bonding electrodes or an impurity concentration of the second bonding electrodes is higher than an impurity concentration of the third bonding electrodes.

16. The semiconductor device according to claim 1, wherein
at least one of a planar shape of the first bonding electrodes or a planar shape of the second bonding electrodes has a quadrangular planar shape.

17. The semiconductor device according to claim 1, wherein
at least one of a planar shape of the first bonding electrodes or a planar shape of the second bonding electrodes has a polygonal planar shape or circular planar shape larger than a quadrangular planar shape.

18. An imaging device comprising:
a first semiconductor in which a plurality of first bonding electrodes is formed;
a second semiconductor in which second bonding electrodes each bonded to a corresponding one of the first bonding electrodes are formed, the second semiconductor being smaller in planar size than the first semiconductor; and
a third semiconductor in which third bonding electrodes each bonded to a corresponding one of the first bonding electrodes are formed, the third semiconductor being smaller in planar size than the first semiconductor, wherein
the second semiconductor and the third semiconductor are bonded to a same surface of the first semiconductor, and
the third bonding electrodes include electrodes formed to be larger in planar size than the second bonding electrodes.
